# EUROPEAN PATENT SPECIFICATION

(11) **EP 1 978 571 B1**
(45) Date of publication and mention of the grant of the patent: **25.04.2012**
(21) Application number: 08102434.1
(22) Date of filing: 10.03.2008
(51) Int. Cl.: H01L 51/00, H01L 51/50, H01L 51/54

(54) **Organic electroluminescent device and display device**
Organische elektrolumineszente Vorrichtung und Anzeigevorrichtung
Dispositif électroluminescent organique et dispositif d'affichage

(30) Priority: 02.04.2007 JP 2007096670
(43) Date of publication of application: 08.10.2008
(73) Proprietor: Fuji Xerox Co., Ltd., Tokyo (JP)
(72) Inventor: Ishii, Toru c/o Fuji Xerox Co., Ltd., Ashigarakami-gun, Kanagawa (JP); Sato, Katsuhiro c/o Fuji Xerox Co., Ltd., Kanagawa (JP); Nishino, Yohei c/o Fuji Xerox Co., Ltd., Kanagawa (JP); Horiba, Koji c/o Fuji Xerox Co., Ltd., Kanagawa (JP); Mashimo, Kiyokazu c/o Fuji Xerox Co., Ltd., Kanagawa (JP); Agata, Takeshi c/o Fuji Xerox Co., Ltd., Kanagawa (JP); Imai, Akira c/o Fuji Xerox Co., Ltd., Ashigarakami-gun, Kanagawa (JP); Ozaki, Tadayoshi c/o Fuji Xerox Co., Ltd., Kanagawa (JP); Hirose, Hidekazu c/o Fuji Xerox Co., Ltd., Kanagawa (JP); Okuda, Daisuke c/o Fuji Xerox Co., Ltd., Ashigarakami-gun, Kanagawa (JP); Yoneyama, Hirohito c/o Fuji Xerox Co., Ltd., Kanagawa (JP); Seki, Mieko c/o Fuji Xerox Co., Ltd., Kanagawa (JP)
(74) Representative: Jones, Helen M.M.

(56) References cited:
- EP-A2- 1 244 154
- US-A1- 2002 050 597
- TOKITO S ET AL: "METAL OXIDES AS A HOLE-INJECTING LAYER FOR AN ORGANIC ELECTROLUMINESCENT DEVICE", JOURNAL OF PHYSICS D. APPLIED PHYSICS, IOP PUBLISHING, BRISTOL, GB, vol. 29, no. 11, 14 November 1996 (1996-11-14), pages 2750-2753, XP000694594, ISSN: 0022-3727, DOI: DOI:10.1088/0022-3727/29/11/004

## Description

### Technical Field

The present invention relates to an organic electroluminescent device and a display device.

### Related Art

Electroluminescent devices, selfluminous all-solid-state devices that are more visible and resistant to shock, are expected to find wider application. The mainstream of the electroluminescent devices are those using an inorganic fluorescent compound.

Researches on electroluminescent devices by using organic compounds started with a single crystal such as that of anthracene. Further, researches on electroluminescent devices having thinner films formed by vacuum-deposition are also started (Thin Solid Films, 94 (1982) pp. 171-183).

Recently, a function-separated laminated-film organic electroluminescent device which has a layer of aromatic diamine and a layer of Alq₃ sequentially laminated in this order and gives a high brightness of 1,000 cd/m² or higher at a low voltage of approximately 10 V has been reported (Appl. Phys. Lett. Vol. 51 (1987) pp. 913-915), and since that research and development on such laminated electroluminescent devices have been in progress intensively.
Such a laminated-film device gives high-brightness emission, while holes and electrons are injected from electrodes through a charge-transporting layer of a charge-transporting organic compound into a light-emitting layer of a fluorescent organic compound and the holes and electrons injected and trapped into the light-emitting layer recombined to each other while the carrier balance between the hole and the electron is maintained.

An organic electroluminescent devices formed using a starburst amine that forms a stable amorphous glass state as a hole-transporting material to suppress generation of Joule heat upon driving of the devices (Proceedings of the 40th Applied Physics Related Associated Seminar, 30a-SZK-14 (1993)), an organic electroluminescent device formed using a polymer polyphosphazenes having triphenylamines in the side chains (Polymer Preprints, Japan, Vol. 42, No. 7, 20J-21 (1993)) have been also reported.

Research and development on single layer electroluminescent devices have also been in progress in view of reducing processing time lengths, and a device formed using conducting polymers such as poly (p-phenylene vinylene) (Nature, Vol. 357 (1992) pp. 477-479), an organic electroluminescent device having an emitting layer formed using a solution containing hole transporting-polyvinylcarbazole mixed with an electron transporting material and a fluorescence dye (Proceedings of the 3 8th Applied Physics Related Associated Seminar, 31p-G-12 (1991)) and the like have been reported.

Further, from the viewpoint of methods for manufacturing electroluminescent devices, researches for a wet application process are in progress in view of simplification of manufacturing process, processing suitability, upsizing and costs. There have been reported organic electroluminescent devices formed by a casting method (Proceedings of the 50th Applied Physics Society Seminar, 29p-ZP-5 (1989) and Proceedings of the 51th Applied Physics Society Seminar, 28a-PB-7 (1990)). Metal oxides as hole-injecting layer for an organic electroluminescent device (Journal of Physics D. Applied Physics (1995) pp. 2750-2753) and an organic LED having high luminous intensity (US 2002/0050597) have also been reported.

### SUMMARY

According to a first embodiment of a first aspect of the present invention, there is provided an organic electroluminescent device comprising an anode and a cathode forming a pair of electrodes, at least one electrode being transparent or translucent, and a buffer layer and an organic compound layer being disposed between the anode and the cathode,
the organic compound layer comprising one or more layers including at least a light-emitting layer;
at least one of the layers of the organic compound layer comprising at least one charge-transporting polyether represented by Formula (I);
at least one of the layers comprising the charge-transporting polyether being provided in contact with the buffer layer; and
the buffer layer being provided in contact with the anode and comprising at least one charge injection material selected from the group consisting of an inorganic oxide, an inorganic nitride, and an inorganic oxynitride.

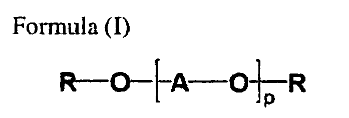

In Formula (I), A represents at least one structure represented by Formula (II-1) or (II-2); R represents a hydrogen atom, an alkyl group, a substituted or unsubstituted aryl group, a substituted or unsubstituted aralkyl group, an acyl group, or a group represented by -CONH-R' (in which R' represents a hydrogen atom, an alkyl group, a substituted or unsubstituted aryl group, or a substituted or unsubstituted aralkyl group); and p is an integer of 5 to 5,000.

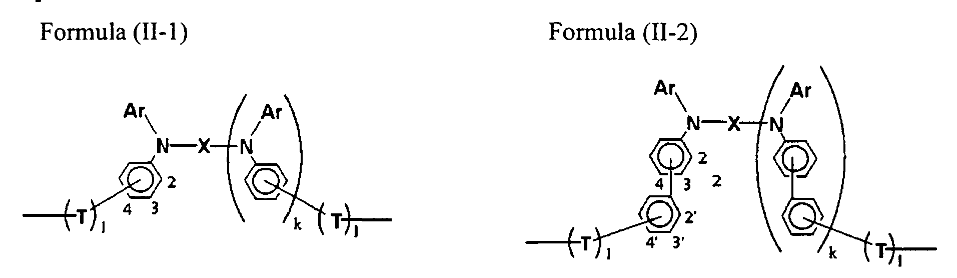

In Formulae (II-1) and (II-2), Ar represents a substituted or unsubstituted monovalent aromatic group; X represents a substituted or unsubstituted divalent aromatic group; k and 1 each is 0 or 1; and T represents a divalent straight-chain hydrocarbon having 1 to 6 carbon atoms or a branched hydrocarbon having 2 to 10 carbon atoms.

In a second embodiment of the first aspect of the present invention, the buffer layer comprises at least one of molybdenum oxide and vanadium oxide.

In a third embodiment of the first aspect of the present invention, Ar in Formulae (II-1) and (II-2) represents a monovalent aromatic group selected from the group consisting of a substituted or unsubstituted benzene group, a substituted or unsubstituted monovalent biphenyl group, a substituted or unsubstituted monovalent naphthalene group, and a substituted or unsubstituted monovalent fluorene group.

In a fourth embodiment of the first aspect of the present invention, T in Formulae (II-1) and (II-2) represents -CH₂-, -(CH₂)₂-, -(CH₂)₃-, or -(CH₂)₄-.

In a fifth embodiment of the first aspect of the present invention, the thickness of the buffer layer is in the range of about 1 nm to about 15 nm.

In a sixth embodiment of the first aspect of the present invention, the organic compound layer comprises the light-emitting layer and an electron-transporting layer, at least the light-emitting layer comprises at least one charge-transporting polyether represented by Formula (I), and the buffer layer is disposed between the anode and the light-emitting layer.

In a seventh embodiment of the first aspect of the present invention, the light-emitting layer further comprises a charge-transporting material other than the charge-transporting polyether.

In an eighth embodiment of the first aspect of the present invention, the organic compound layer comprises a hole-transporting layer, the light-emitting layer, and an electron-transporting layer, at least the hole-transporting layer comprises at least one charge-transporting polyether represented by Formula (I), and the buffer layer is disposed between the anode and the hole-transporting layer.

In a ninth embodiment of the first aspect of the present invention, the light-emitting layer further comprises a charge-transporting material other than the charge-transporting polyether.

In a tenth embodiment of the first aspect of the present invention, the organic compound layer comprises a hole-transporting layer and the light-emitting layer, at least the hole-transporting layer comprises at least one charge-transporting polyether represented by Formula (I), and the buffer layer is disposed between the anode and the hole-transporting layer.

In an eleventh embodiment of the first aspect of the present invention, the light-emitting layer further comprises a charge-transporting material other than the charge-transporting polyether.

In a twelfth embodiment of the first aspect of the present invention, the organic compound layer consists of the light-emitting layer, the light-emitting layer has a charge-transporting property, the light-emitting layer comprises at least one charge-transporting polyether represented by Formula (I), and the buffer layer is disposed between the anode and the light-emitting layer.

In a thirteenth embodiment of the first aspect of the present invention, the light-emitting layer further comprises a charge-transporting material other than the charge-transporting polyether.

Further, according to an embodiment of a second aspect of the present invention, there is provided an display device comprising:
a substrate;
a plurality of organic electroluminescent devices disposed on the substrate and arranged in a matrix form; and
a driving unit that drives the organic electroluminescent devices,
each of the organic electroluminescent devices being the organic electroluminescent device of any one of the first to thirteenth embodiments of the first aspect of the present invention.

### Brief Description of the Drawings

Figure 1 is a schematic sectional view illustrating an exemplary embodiment of layer structure of organic electroluminescent device of the present invention;
Figure 2 is a schematic sectional view illustrating another exemplary embodiment of layer structure of organic electroluminescent device of the present invention;
Figure 3 is a schematic sectional view illustrating another exemplary embodiment of layer structure of organic electroluminescent device of the present invention; and
Figure 4 is a schematic sectional view illustrating another exemplary embodiment of layer structure of organic electroluminescent device of the present invention.

### Detailed Description

Hereinafter, exemplary embodiments of the invention will be described in detail.

The organic electroluminescent device in the exemplary embodiment has an anode and a cathode, at least one of which is transparent or translucent (the "transparent" or "translucent" herein used to express a condition such that the transmittance of a material for visible light is at least about 50% or more), and a buffer layer and an organic compound layer disposed between the anode and the cathode.

The organic compound layer has at least one layer including at least a light-emitting layer. At least one layers in the organic compound layer has at least one charge-transporting polyether represented by Formula (I).

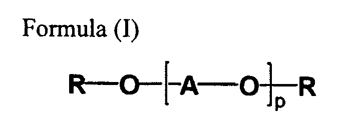

In Formula (I), A represents at least one structure represented by Formula (II-1) or (II-2); R represents a hydrogen atom, an alkyl group, a substituted or unsubstituted aryl group, a substituted or unsubstituted aralkyl group, an acyl group, or a group represented by -CONH-R' (in which R' represents a hydrogen atom, an alkyl group, a substituted or unsubstituted aryl group, or a substituted or unsubstituted aralkyl group); and p is an integer of 5 to 5,000.

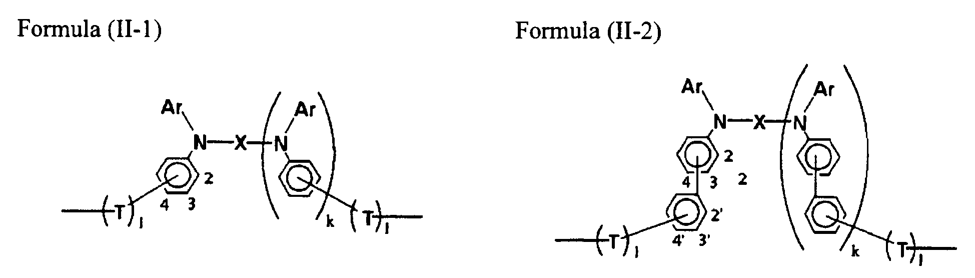

In Formulae (II-1) and (II-2), Ar represents a substituted or unsubstituted monovalent aromatic group; X represents a substituted or unsubstituted divalent aromatic group; k and 1 each is 0 or 1; and T represents a divalent straight-chain hydrocarbon having 1 to 6 carbon atoms or a branched hydrocarbon having 2 to 10 carbon atoms.

At least one of the layers comprising the charge-transporting polyether is provided in contact with the buffer layer. The buffer layer is provided in contact with the anode.

The buffer layer has at least one charge injection material selected from the group consisting of an inorganic oxide, an inorganic nitride, and an inorganic oxynitride.

The organic electroluminescent device of the invention allows improved brightness, stability, and durability via the configuration and structure described above.
Although the reason why the above configuration and structure improve the brightness, stability, and durability of the organic electroluminescent device is not known, it is thought to be due to the charge injection material in the buffer layer decreasing the energy barrier between the anode and the organic compound layer, thereby not only increasing the charge injection properties and improving the adhesion between the anode and the buffer layer, but also improving the adhesion between the buffer layer and the organic compound layer containing the specific charge transporting polyether. Furthermore, as the specific charge transporting polyether contained in the organic compound layer has high charge mobility and a high glass transition temperature, it is thought to improve the brightness, stability, and durability of the organic electroluminescent device.
In addition, inclusion of an organic material in the major functional layers such as a light-emitting layer facilitates area enlargement, and production.

Details about the layers are described below.

Buffer layer
The charge injection material included in the buffer layer is at least one inorganic material selected from the group consisting of an inorganic oxide, an inorganic nitride, and an inorganic oxynitride.

Examples of the inorganic oxide include oxides and complex oxides of any one of transition metals including rare earth elements, aluminum, silicon, zinc, gallium, germanium, cadmium, indium, tin, antimony, thallium, lead, and bismuth, while the inorganic oxides are not limited thereto.

Examples of the inorganic nitride include nitrides and complex nitrides of any one of gallium, indium, aluminum, magnesium, lithium, magnesium, molybdenum, vanadium, lanthanum, chromium, silicon, boron, iron, copper, zinc, barium, titanium, yttrium, calcium, tantalum, and zirconium, while the inorganic nitrides are not limited thereto.

Examples of the inorganic oxynitride include a sialon, which is an oxynitride prepared by solid-dissolving Al₂O₃ (alumina), SiO₂ (silica), or the like in Si₃N₄ (silicon nitride), a complex sialon containing lithium, calcium, barium, lanthanum, or the like, and a hypercomplex sialon prepared by solid-dissolving other inorganic oxide or inorganic nitride in sialon, while the inorganic oxynitrides are not limited thereto.

Among these specific inorganic oxides, inorganic nitrides, and inorganic oxynitrides, molybdenum oxide and vanadium oxide are preferably used in the invention.

When the buffer layer contains molybdenum oxide and/or vanadium oxide, the organic electroluminescent device has even higher brightness.
The reason why the structure further improves the brightness of the organic electroluminescent device is not known, however is likely due to that molybdenum oxide and vanadium oxide efficiently decrease the energy barrier between the anode and the organic compound layer, and that molybdenum oxide and vanadium oxide have lower absorptance for visible light and can be processed into thinner films in comparison with other substances thereby efficiently transmit light so as to improve the light extraction efficiency of the organic electroluminescent device.

The thickness of the buffer layer is preferably in the range of about 1 to about 200 nm, is more preferably in the range of about 1 nm to about 15 nm, and is even more preferably in the range of about 5 nm to about 15 nm.

When the thickness of the buffer layer is within any one of the ranges, the organic electroluminescent device has even higher brightness.
The reason why the thickness of the buffer layer within any one of the ranges further improves the brightness of the organic electroluminescent device is not known, while it is likely due to that the combination of the achievement of the charge injection properties of the buffer layer and the achievement of light transmitting properties of the buffer layer further improves the brightness of the organic electroluminescent device.
The thickness of the buffer layer can be measured with a film thickness sensor.

Organic compound layer(s)
At least one of the layer(s) in the organic compound layer includes the charge-transporting polyether. Hereinafter, the charge-transporting polyether is explained in detail.

The charge-transporting polyether is represented by Formula (I). In Formula (I), A represents at least one structure represented by Formula (II-1) or (II-2).

Specific examples of the structure represented by Formula (II-1) or (II-2) includes a substituted or unsubstituted phenyl group, a substituted or unsubstituted monovalent polynuclear aromatic hydrocarbon, a substituted or unsubstituted monovalent condensed ring-aromatic hydrocarbon, a substituted or unsubstituted monovalent aromatic heterocyclic ring, and a substituted or unsubstituted monovalent aromatic group having at least one aromatic heterocyclic ring.

The "polynuclear aromatic hydrocarbon" is a hydrocarbon compound having two or more aromatic rings composed of carbon and hydrogen that are bound to each other by a carbon-carbon single bond. The "condensed ring-aromatic hydrocarbon" is a hydrocarbon compound having two or more aromatic rings composed of carbon and hydrogen that are bound to each other via a pair of two or more carbon atoms nearby connected to each other.

While the number of atoms constituting the aromatic rings constituting the polynuclear aromatic hydrocarbon or the condensed ring-aromatic hydrocarbon represented by Ar in Formulae (II-1) and (II-2) is not particularly limited, it is preferably in the range of about 2 to about 5. Further, the condensed ring-aromatic hydrocarbon is particularly preferably an all-condensed ring-aromatic hydrocarbon, which herein means a condensed ring-aromatic hydrocarbon in which all aromatic rings included therein are continuously adjacent to have condensed structures.

Specific examples of the polynuclear aromatic hydrocarbon include biphenyl, terphenyl and the like. Specific examples of the condensed ring-aromatic hydrocarbon include naphthalene, anthracene, phenanthrene, fluorene and the like.

The "aromatic heterocyclic ring" represents an aromatic ring containing an element other than carbon and hydrogen. The number of atoms constituting the ring skeleton (Nr) is preferably 5 and/or 6. The kinds and the number of the elements other than C (foreign elements) constituting the ring skeleton is not particularly limited, however the element is preferably, for example, S, N, or O, and two or more kinds of and/or two or more foreign atoms may be contained in the ring skeleton. In particular, heterocyclic rings having a five-membered ring structure, such as thiophene, thiofin and furan, a heterocyclic ring substituted with nitrogen at the 3- and 4-positions thereof, pyrrole, or a heterocyclic ring further substituted with nitrogen at the 3- and 4-positions, are used preferably, and heterocyclic rings having a six-membered ring structure such as pyridine are also used preferably.

The "aromatic group containing an aromatic heterocyclic ring" is a binding group having at least such an aromatic heterocyclic ring in the atomic group constituting the skeleton. The group may be an entirely conjugated system or a system at least partially non-conjugated, however an entirely conjugated system is favorable from the points of charge-transporting property and luminous efficiencies.

Examples of the substituents on the phenyl group, the polynuclear aromatic hydrocarbon, the condensed ring-aromatic hydrocarbon, the aromatic heterocyclic ring, or aromatic group containing an aromatic heterocyclic ring represented by Ar include a hydrogen atom, an alkyl group, an alkoxy group, a phenoxy group, an aryl group, an aralkyl group, a substituted amino group, a halogen atom and the like.

The alkyl group preferably has 1 to 10 carbon atoms, and examples thereof include a methyl group, an ethyl group, a propyl group, an isopropyl group and the like. The alkoxyl group preferably has 1 to 10 carbon atoms, and examples thereof include a methoxy group, an ethoxy group, a propoxy, and an isopropoxy group. The aryl group preferably has 6 to 20 carbon atoms, and examples thereof include a phenyl group and a tolyl group. The aralkyl group preferably has 7 to 20 carbon atoms, and examples thereof include a benzyl group and a phenethyl group. The substituent groups on the substituted amino group include an alkyl group, an aryl group and an aralkyl group, and specific examples thereof include those described above.

Among the specific examples, Ar is preferably a monovalent aromatic group selected from benzene, biphenyl, naphthalene, and fluorene.
When Ar is one of the substituents, the brightness, stability, and durability of the organic electroluminescent device is further improved.
The reason why the substituent improves the brightness, stability, and durability of the organic electroluminescent device is not known, while it is likely due to the improvement in the adhesion with the buffer layer.

In Formulae (II-1) and (II-2), X represents a substituted or unsubstituted divalent aromatic group. Specific examples of the group X include substituted or unsubstituted phenylene groups, substituted or unsubstituted divalent polynuclear aromatic hydrocarbons having 2 to 10 aromatic rings, substituted or unsubstituted divalent condensed ring-aromatic hydrocarbons having 2 to 10 aromatic rings, substituted or unsubstituted divalent aromatic heterocyclic rings, and substituted or unsubstituted divalent aromatic groups having at least one aromatic heterocyclic ring.

The "polynuclear aromatic hydrocarbon", the "condensed ring-aromatic hydrocarbon", the "aromatic heterocyclic ring", and the "aromatic group containing an aromatic heterocyclic ring" are the same as those described above.

In Formulae (II-1) and (II-2), T represents a divalent straight-chain hydrocarbon group having 1 to 6 carbon atoms or a divalent branched hydrocarbon group having 2 to 10 carbon atoms, and is preferably represents a group selected from a divalent straight-chain hydrocarbon group having 2 to 6 carbon atoms and a divalent branched hydrocarbon groups having 3 to 7 carbon atom. Specific structures of T are shown below.

**-CH=CH-, -CH=CH-CH=CH-, -CH₂-CH=CH-CH₂-_{'}**

**-CH₂-, -(CH₂)₂-, -(CH₂)₃ -, - (CH₂)₄- -(CH₂)₅-, -(CH₂)₆-,**

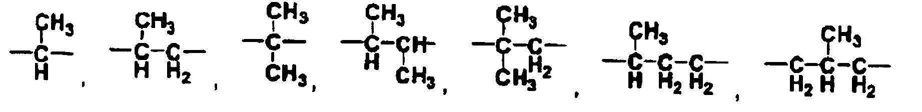

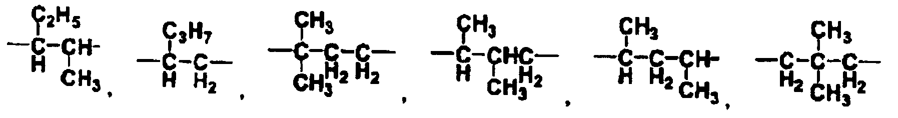

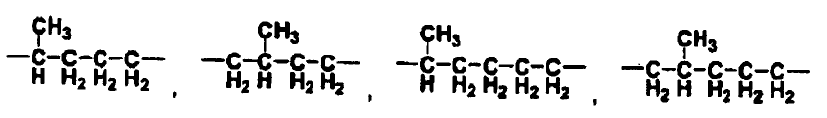

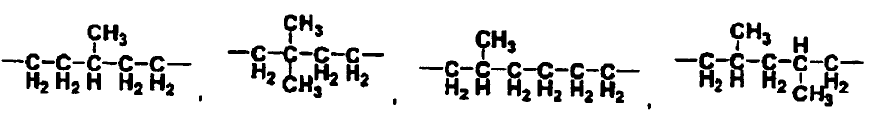

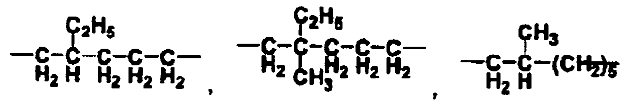

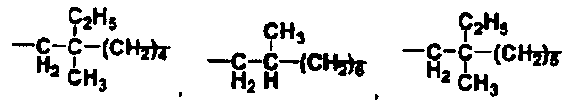

Among the specific examples, T preferably represents -CH₂-, -(CH₂)₂-, -(CH₂)₃-, or -(CH₂)₄-. When T is one of the specific substituents, the brightness, stability, and durability of the organic electroluminescent device is further improved. The reason why the substituent improves the brightness, stability, and durability of the organic electroluminescent device is not known, while it is likely due to that the resultant charge transporting polyether has a particularly high glass transition temperature, and offers improved adhesion with the buffer layer.

In Formula (I), A represent at least one structure represented by Formula (II-1) or (II-2). One or more of the structure represented by A can be included in the polymer represented Formula (I).

In Formula (I), R represents a hydrogen atom, an alkyl group, a substituted or unsubstituted aryl group, a substituted or unsubstituted aralkyl group, an acyl group or a group represented by -CONH-R'.

The alkyl group preferably has 1 to 10 carbon atoms, and examples thereof include a methyl group, an ethyl group, a propyl group, and an isopropyl group. The aryl group preferably has 6 to 20 carbon atoms, and examples thereof include a phenyl group and a tolyl group. The aralkyl group preferably has 7 to 20 carbon atoms, and examples thereof include a benzyl group and a phenethyl group. Examples of the substituent group(s) on the substituted aryl group or the substituted aralkyl group include a hydrogen atom, an alkyl group, an alkoxy group, a substituted amino group, a halogen atom, and the like.

Examples of the acyl group include an acryloyl group, a crotonoyl group, a methacryloyl group, an n-butyloyl group, a 2-furoyl group, a benzoyl group, a cyclohexanecarbonyl group, an enanthyl group, a phenyl acetyloyl group, and a toluyl group.

R' in the group -CONH-R' represents a hydrogen atom, an alkyl group, a substituted or unsubstituted aryl group, or a substituted or unsubstituted aralkyl group.

In Formula (I), p indicates a polymerization degree in the range of about 5 to about 5,000, which preferably indicates in the range of about 10 to about 1,000.

The weight average molecular weight Mw of the charge-transporting polyether is preferably in the range of about 5,000 to about 1,000,000, and is more preferably in the range of about 10,000 to about 300,000.

The weight average molecular weight Mw of the charge-transporting polyether can be determined by the following method.
The weight-average molecular weight is determined, by first preparing a 1.0 % by weight charge-transporting polyether THF (tetrahydrofuran) solution and analyzing the solution by gel penetration chromatography (GPC) by using a differential refractometer (RI, manufactured by TOSOH corp., trade name: UV-8020) while styrene polymers is used as calibration samples.

Specific examples of the charge-transporting polyether represented by Formula (I) include those described in any one of JP-A Nos. 8-176293 and 8-269446.

Hereinafter, the method of preparing the charge-transporting polyether will be described. The charge-transporting polyether represented by Formula (I) can be prepared in any one of the following synthesis methods 1 to 3.

The charge transporting polyether can be synthesized, for example, through dehydration condensation under heating of the charge transporting monomer represented by the following Formula (III-1) or (III-2) (synthesis method 1).

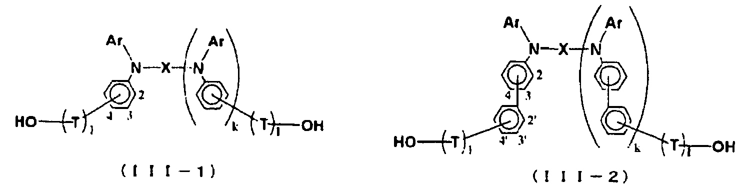

In Formulae (III-1) and (III-2), Ar, X, T, k, 1, and m are the same as those in Formula (II-1) or (II-2) above.

In a case where the charge transporting polyether is synthesized by the synthesis method 1, the charge transporting monomer represented by Formula (III-1) or (III-2) is preferably heat-melted with no solvent, thereby accelerating polymerization by water desorption under reduced pressure.

In cases where a solvent is used when the charge transporting polyether is synthesized by the synthesis method 1, water generated during polymerization can be effectively removed by using a solvent which is capable of azeotropically boiling with water. Examples thereof include trichloroethane, toluene, chlorobenzene, dichlorobenzene, nitrobenzene, 1-chloronaphthalene and the like. The amount of the solvent is preferably about 1 equivalent to about 100 equivalents, and is more preferably about 2 equivalents to about 50 equivalents per equivalent of the charge transporting monomer.

In a case where the charge transporting polyether is synthesized by the synthesis method 1, the reaction temperature is not particularly limited, while the reaction is preferably carried out at the boiling point of the solvent to remove water generated during polymerization. If order to promote the proceeding of the polymerization, the solvent may be removed from the reaction system, and the monomer may be stirred under heating in a viscous state.

Alternatively, the charge transporting polyether may be synthesized by a method including dehydration condensation of the charge transporting monomer represented by the following Formula (III-1) or (III-2) with an acid catalyst (synthesis method 2).

Examples of the acid catalyst include a protonic acid such as p-toluenesulfonic acid, hydrochloric acid, sulfuric acid, or trifluoroacetic acid, and a Lewis acid such as zinc chloride. In this case, the amount of the acid catalyst is preferably about 1/10,000 equivalents to about 1/10 equivalents, more preferably about 1/1,000 equivalents to about 1/50 equivalents per equivalent of the charge transporting monomer.

In order to remove water generated during polymerization, it is preferable to use a solvent capable of azeotropically boiling with water. Examples of effective solvents include toluene, chlorobenzene, dichlorobenzene, nitrobenzene, and 1-chloronaphthalene. The amount of the solvent is preferably about 1 equivalent to about 100 equivalents, more preferably about 2 equivalents to about 50 equivalents of the charge transporting monomer.

In a case where the charge transporting polyether is synthesized by the synthesis method 2, the reaction temperature is not particularly limited, while the reaction is preferably carried out at the boiling point of the solvent to remove water generated during polymerization.

Alternatively, the charge transporting polyether may be synthesized by condensing the charge transporting monomer represented by the following Formula (III-1) or (III-2) using a condensing agent.

Examples of the condensing agent include: an alkyl isocyanide such as cyclohexyl isocyanide; an alkyl cyanide such as cyclohexyl cyanide; a cyanate ester such as p-tolyl cyanate or 2,2-bis(4-cyanatephenyl)propane; dichlorohexyl carbodiimide (DCC); or trichloroacetonitrile (synthesis method 3). In this case, the amount of the condensing agent is preferably about 1/2 equivalent to about 10 equivalents, more preferably about 1 equivalent to about 3 equivalents per equivalent of the charge transporting monomer.

Examples of effective solvents preferably used in a case where the charge transporting polyether is formed by the synthesis method 3 include toluene, chlorobenzene, dichlorobenzene, and 1-chloronaphthalene. The amount of the solvent is preferably about 1 equivalent to about 100 equivalents, more preferably about 2 equivalents to about 50 equivalents per equivalent of the charge transporting monomer.

In a case where the charge transporting polyether is formed by the synthesis method 3, the reaction temperature is not particularly limited, while the reaction is preferably carried out, for example, at a temperature from room temperature (for example 25°C) to the boiling point of the solvent.

Among the synthesis methods 1, 2, and 3, the synthesis methods 1 or 3 are preferable from the viewpoint that they do not readily undergo isomerization or side reactions. In particular, the synthesis method 3 is more preferable because of its milder reaction conditions.

After the reaction for polymerizing the charge transporting polyether, a precipitation process can be performed. In a case where no solvent is used for polymerizing the charge transporting polyether, the resulted reactant of the polymerization can be dissolved in a solvent to which the charge transporting polyether can be well dissolved so as to obtain a polyether solution. In a case where a solvent is used for polymerizing the charge transporting polyether, the resulted reaction solution can be used as a polyether solution as it is.
Next, the thus obtained polyether solution is added dropwise into a poor solvent for the charge transporting polyether such as alcohol (such as methanol or ethanol) or acetone, allowing precipitation of the charge-transporting polyether, and, after separation, the charge-transporting polyether is washed with water and an organic solvent thoroughly and dried.

If needed, the precipitation process may be repeated, by dissolving the polyester in a suitable organic solvent and adding the solution dropwise into a poor solvent, thus, precipitating the charge-transporting polyether.

During the precipitation process, the reaction mixture is preferably efficiently stirred thoroughly by using a mechanical stirrer or the like.
The solvent for dissolving the charge-transporting polyether during the precipitation process is preferably used in an amount in the range of about 1 to about 100 parts by weight, preferably in the range of about 2 to about 50 parts by weight, with respect to 1 part by weight of the charge-transporting polyether. The poor solvent can be used in an amount in the range of about 1 to about 1,000 parts by weight, preferably in the range of about 10 to about 500 parts by weight, with respect to 1 part by weight of the charge-transporting polyether.

In the reaction, a copolymer may be synthesized using two or more, preferably two to five, even more preferably two or three kinds of charge transporting monomers. Copolymerization with different kinds of charge transporting monomers allows the control of electrical properties, film-forming properties, and solubility.

The terminal group of the charge transporting polyether may be, in common with the charge transporting monomer, a hydroxyl group (in other words R in the formula (I) may be a hydrogen atom), while the terminal group R may be modified to control the polymer properties such as solubility, film forming properties, and mobility.

For example, the terminal hydroxyl group of the charge transporting polyether may be alkyl-etherified with, for example, alkyl sulfate or alkyl iodide. Specific examples of the reagent for the alkyl etherification reaction include dimethyl sulfate, diethyl sulfate, methyl iodide, and ethyl iodide. The amount of the reagent is preferably about 1 equivalent to about 3 equivalents, more preferably about 1 equivalent to about 2 equivalents per equivalent of the terminal hydroxyl group. A base catalyst may be used for the alkyl etherification reaction. Examples of the base catalyst include sodium hydroxide, potassium hydroxide, hydrogenated sodium, and metallic sodium. The amount of the base catalyst is preferably about 1 equivalents to about 3 equivalents, more preferably about 1 equivalent to about 2 equivalents per equivalent of the terminal hydroxyl group.

The temperature of the alkyl etherification reaction can be, for example, from 0°C to the boiling point of the solvent used. Examples of the solvent used for the alkyl etherification reaction include a single solvent or a mixed solvent composed of two to three kinds of solvents selected from inactive solvents such as benzene, toluene, methylene chloride, tetrahydrofuran, N,N-dimethylfonnamide, dimethyl sulfoxide, N-methylpyrrolidone, or 1,3-dimethyl-2-imidazolidinone.
As necessary, a quaternary ammonium salt such as tetra-n-butyl ammonium iodide may be used as a phase transfer catalyst.

The hydroxyl group at the terminal of the charge transporting polyether may be acylated using an acid halide (in other words, R in Formula (I) may be an acyl group).
The acid halide is not particularly limited, and examples thereof include acryloyl chloride, crotonyl chloride, methacryloyl chloride, 2-furoyl chloride, benzoyl chloride, cyclohexanecarbonyl chloride, enanthyl chloride, phenylacetyl chloride, o-toluoyl chloride, m-toluoyl chloride, and p-toluoyl chloride. The amount of the acid halide is preferably about 1 equivalent to about 3 equivalents, more preferably about 1 equivalent to about 2 equivalents per equivalent of the terminal hydroxyl group.
A base catalyst may be used for the acylation reaction. Examples of the base catalyst include pyridine, dimethylamino pyridine, trimethylamine, and triethylamine. The amount of the base catalyst is preferably about 1 equivalent to about 3 equivalents, more preferably about 1 equivalent to about 2 equivalents per equivalent of the acid halide.

Examples of the solvent used for the acylation include benzene, toluene, methylene chloride, tetrahydrofuran, and methyl ethyl ketone.
The temperature of the acylation reaction may be, for example, from 0°C to the boiling point of the solvent used. The reaction temperature is preferably from 0°C to 30°C.

The acylation reaction may be carried out using an acid anhydride such as acetic anhydride. In a case where the acylation reaction is carried out using an acid anhydride, a solvent may be used. Specific examples of the solvent include an inert solvent such as benzene, toluene, or chlorobenzene. The temperature of the acylation reaction with an acid anhydride is, for example, from about 0°C to the boiling point of the solvent used. The reaction temperature is preferably from about 50°C to the boiling point of the solvent used.

The terminal hydroxyl group of the charge transporting polyether may be alkyl etherified or acylated as described above. Alternatively, a urethane residue may be introduced into the terminal of the charge transporting polyether using a monoisocyanate (in other words, R in the formula (I) may be modified to be a group represented by -CONH-R'). Specific examples of such a monoisocyanate include benzyl ester isocyanate, n-butyl ester isocyanate, t-butyl ester isocyanate, cyclohexyl ester isocyanate, 2,6-dimethyl ester isocyanate, ethyl ester isocyanate, isopropyl ester isocyanate, 2-methoxyphenyl ester isocyanate, 4-methoxyphenyl ester isocyanate, n-octadecyl ester isocyanate, phenyl ester isocyanate, isopropyl ester isocyanate, m-tolyl ester isocyanate, p-tolyl ester isocyanate, and 1-naphthylester isocyanate. The amount of the monoisocyanate is preferably about 1 equivalent to about 3 equivalent, more preferably about 1 equivalent to about 2 equivalents per equivalent of the terminal hydroxyl group.

Examples of the solvent used for the introduction of a urethane residue include benzene, toluene, chlorobenzene, dichlorobenzene, methylene chloride, tetrahydrofuran, N,N-dimethylformamide, dimethyl sulfoxide, N-methylpyrrolidone, and 1,3-dimethyl-2-imidazolidinone.

The reaction temperature for the introduction of a urethane residue into the terminal of the charge transporting polyether is, for example, from about 0° to the boiling point of the solvent used. If the reaction does not readily proceed, a catalyst may be added. Examples of the catalyst include a metal compound such as dibutyltin (II) dilaurate, octyltin (II), or lead naphthenate, or a tertiary amine such as triethylamine, trimethylamine, pyridine, or dimethylaminopyridine.

Layer structure of Organic electroluminescent device
Hereinafter, the layer structure of the organic electroluminescent device of one exemplary embodiment of the invention will be described.

The organic electroluminescent device of one exemplary embodiment of the invention has a configuration having an electrode pair of an anode and a cathode, at least one of which is transparent or translucent, and an buffer layer and an organic compound layer disposed between the anode and the cathode.

In the organic electroluminescent device in accordance with the exemplary embodiment, when the organic compound layer is composed of a single layer, the organic compound layer refers to a "light-emitting layer having a carrier-transporting property", wherein the light-emitting layer contains the charge transporting polyether. When the organic compound layer is composed of a plurality of layers (separated-function type), at least one of the layers is a light-emitting layer, and the other organic compound layer(s) may include a carrier transporting layer(s) such as a hole transporting layer and/or an electron transporting layer, in which at least one of the layers contains the charge transporting polyether. Specifically, the organic compound layer can have: a layer configuration having at least one light-emitting layer and one electron transporting layer; a layer configuration having at least one hole transporting layer, one light-emitting layer, and one electron transporting layer; or a layer configuration having at least one hole transporting layer and one light-emitting layer, wherein at least one of the layers (hole transporting layer, light-emitting layer, and electron transporting layer) includes the charge transporting polyether. In the organic electroluminescent device of the invention, the light-emitting layer may have a charge transporting materials (an electron hole transporting material and/or an electron transporting material, which is other than the charge transporting polyether). Details are described below.

Hereinafter, the organic electroluminescent device in the exemplary embodiment will be described in more detail with reference to drawings, while the invention is not limited by these exemplary embodiments.

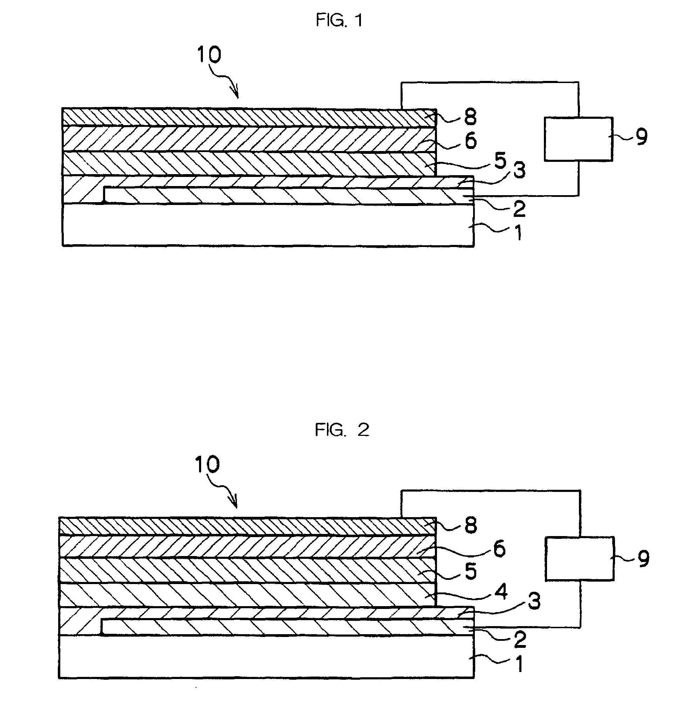

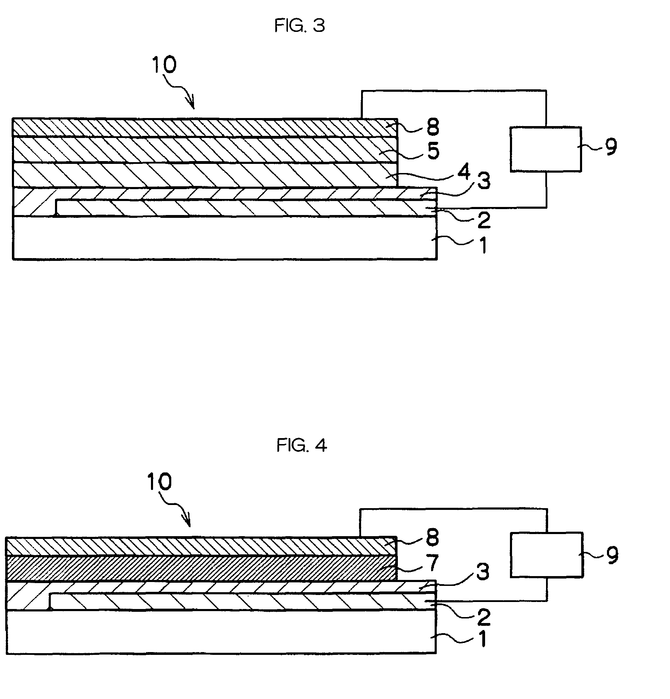

Figures 1 to 4 are schematic sectional views illustrating the layer structure of the organic electroluminescent devices according to aspects of the invention, and Figures 1, 2, and 3 respectively show examples of the devices having plural organic compound layers, while Figure 4 shows an example of the device having one organic compound layer. The invention will be described hereinafter, as the same codes are allocated to the units having the same function in Figures 1 to 4.

The organic electroluminescent device 10 shown in Figure 1 has a transparent insulator substrate 1, and a transparent electrode 2, a buffer layer 3, a light-emitting layer 5, an electron-transporting layer 6 and a rear-face electrode 8 formed thereon successively. At least the light-emitting layer 5 has a charge transporting polyether.

By having the above-described structure, the organic electroluminescent device achieves both of the improved easiness in production and the luminescence efficiency in comparison with devices having other layer structures.
Although the reason why the structure makes production easier and also improves luminescence efficiency in comparison with other layer structures is not known, it is thought to be due to the layer structure having fewer layers in comparison with other layer structures that divide all the functions into separate layers, and thereby, the injection efficiency of electrons, which generally have lower mobility than holes, is supplemented, thus balancing the charges in the light-emitting layer.

The organic electroluminescent device 10 shown in Figure 2 has a transparent insulator substrate 1, and a transparent electrode 2, a buffer layer 3, a hole-transporting layer 4, a light-emitting layer 5, an electron-transporting layer 6 and a rear-face electrode 8 formed thereon successively. At least the hole-transporting layer 4 has a charge transporting polyether.

By having the above-described structure, the organic electroluminescent device achieves both of the improved luminescence efficiency and capability to drive at a lower voltage in comparison with devices having other layer structures.
Although the reason why the structure achieves both of improved luminescence efficiency and improved driving capability at a lower voltage in comparison with other layer structures is not known, it is thought to be due to the separation of all the functions, which maximizes the injection efficiency in comparison with other layer structures, and the charges being recombinable in the light-emitting layer.

The organic electroluminescent device 10 shown in Figure 3 has a transparent insulator substrate 1, and a transparent electrode 2, a buffer layer 3, a hole-transporting layer 4, a light-emitting layer 5 and a rear-face electrode 8 formed thereon in this order. At least the hole-transporting layer 4 has a charge transporting polyether.

By having the above-described structure, the organic electroluminescent device achieves both of the improved easiness in production and the durability in comparison with devices having other layer structures.
Although the reason why the structure makes production easier and improves durability in comparison with other layer structures is not known, it is thought to be due to the layer structure having fewer layers in comparison with other layer structures that divide all the functions into separate layers, thereby improving the efficiency of the injection of holes into the light-emitting layer, and suppressing excessive injection of electrons in the light-emitting layer.

The organic electroluminescent device 10 shown in Figure 4 has a transparent insulator substrate 1, and a transparent electrode 2, a buffer layer 3, a carrier-transporting light-emitting layer 7, and a rear-face electrode 8 formed thereon in this order. At least the carrier-transporting light-emitting layer 7 has a charge transporting polyether.

By having the above-described structure, the organic electroluminescent device achieves both of the improved easiness in production and upsizing in comparison with devices having other layer structures.
Although the reason why the structure makes production and area enlargement easier in comparison with other layer structures is not known, it is thought to be due to the layer structure having fewer layers in comparison with other layer structures, thereby allowing manufacture by a wet application process or the like.

The light-emitting layer 5 and the light-emitting layer 7 having a carrier-transporting property may have a charge transporting material (an electron hole transporting material other than the charge transporting polyether, and/or an electron transporting material).

By having the above-described structure, the organic electroluminescent device achieves the resistance to charge buildup to improve durability.
Although the reason why the structure achieves the resistance to charge buildup thereby improving durability is not known, it is thought to be due to the charge transporting property being improved or imparted to the layer, thereby providing the layer with resistance to charge buildup.

Among the organic compound layers having the specific charge transporting polyether, the thickness of the organic compound layer in contact with the buffer layer is preferably about 20 nm to about 100 nm.

Hereinafter, each component will be described in detail.

The layer having the charge-transporting polyether may function as a light-emitting layer 5 or an electron-transporting layer 6, depending on its structure, in the layer structure of the organic electroluminescent device 10 shown in Figure 1; as a hole-transporting layer 4 or an electron-transporting layer 6, in the layer structure of the organic electroluminescent device 10 shown in Figure 2; as a hole-transporting layer 4 or a light-emitting layer 5, in the layer structure of the organic electroluminescent device 10 shown in Figure 3; and as a light-emitting layer 7 having a carrier-transporting property in the layer structure of the organic electroluminescent device 10 shown in Figure 4. In particular, the charge-transporting polyether functions preferably as a hole-transporting material.

The transparent insulator substrate 1 shown in any one of Figures 1 to 4 is preferably transparent for light transmission, and examples thereof include, but are not limited to, glass, plastic film, and the like.

The transparent electrode 2 is also preferably transparent for light transmission, similarly to the transparent insulator substrate, and has a large work function (ionization potential) for hole injection, and examples thereof include, but are not limited to, oxide layers such as of indium tin oxide (ITO), tin oxide (NESA), indium oxide, and zinc oxide, and metal films, such as of gold, platinum, and palladium, formed by vapor deposition or sputtering.

In the case where the organic electroluminescent device 10 has a configuration of the organic electroluminescent device shown in Figure 1 or 2, the electron-transporting layer 6 may be formed only with the charge-transporting polyether with an added function (electron-transporting property) according to applications, but may be formed together with an electron-transporting material other than the charge-transporting polyether in an amount in the range of 1 to 50 wt%, for example for further improvement in electrical characteristics for control of electron transfer efficiency.
Preferable examples of the electron-transporting materials include oxazole compounds, oxadiazole compounds, nitro-substituted fluorenone compounds, diphenoquinone compounds, thiopyranedioxide compounds, fluorenylidenemethane compounds and the like. Particularly preferable examples thereof include, but are not limited to, the following exemplary compounds (V-1) to (V-3): When the electron-transporting layer 6 is formed without use of the charge-transporting polyether, the electron-transporting layer 6 is formed with the electron-transporting material.

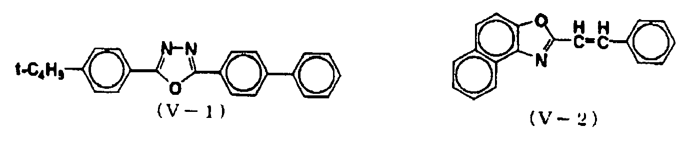

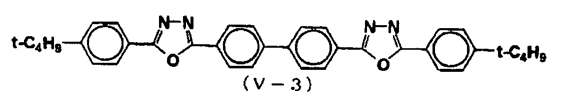

In the case where the organic electroluminescent device 10 has a configuration of the organic electroluminescent device shown in Figure 2 or 3, the hole-transporting layer 4 may be formed only with a charge-transporting polyether with an added functional (hole-transporting property) according to applications. Alternatively, the hole-transporting layer 4 may be formed together with a hole-transporting material other than the charge-transporting polyether in an amount in the range of equal to or approximately 1 to equal to or approximately 50 wt%, in view of controlling the hole mobility.
Preferable examples of the hole-transporting materials include tetraphenylenediamine compounds, triphenylamine compounds, carbazole compounds, stilbene compounds, arylhydrazone compounds, porphyrin compounds, and the like. More preferable examples thereof include the following exemplary compounds (VI-1) to (VI-7), and tetraphenylenediamine compound are particularly preferable, because they are superior in compatibility with the charge-transporting polyether. The material may be used as mixed, for example, with another common resin. When the hole-transporting layer 4 is formed without using the charge-transporting polyether, the hole-transporting layer 4 is formed with the hole-transporting material.

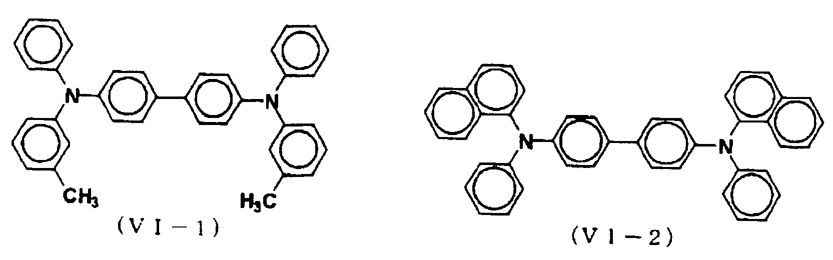

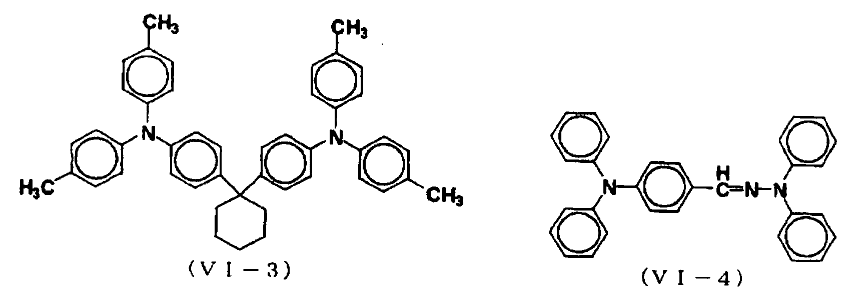

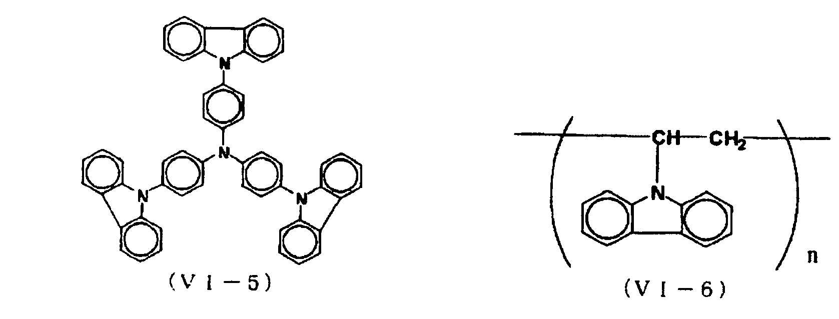

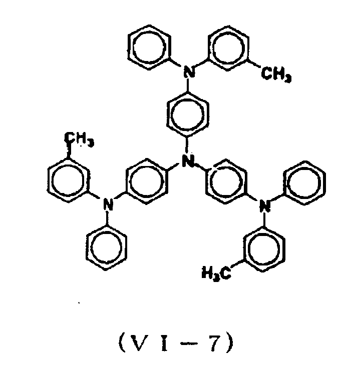

In the exemplary compound (VI-6), p is an integer, which is preferably in the range of equal to or approximately 10 to equal to or approximately 100,000, more preferably in the range of equal to or approximately 1,000 to equal to or approximately 50,000.

In the case where the organic electroluminescent device 10 has a configuration of the organic electroluminescent device shown in Figure 1, 2 or 3, a compound having a fluorescence quantum yield higher than that of other compounds in the solid state is used as the light-emitting material in the light-emitting layer 5. When the light-emitting material is an organic low-molecular weight, the compound should give a favorable thin film by vacuum deposition or by coating/drying of a solution or dispersion containing a low-molecular weight compound and a binder resin. Alternatively when it is a polymer, it should give a favorable thin film by coating/drying of a solution or dispersion containing it.

If the light-emitting material is an organic low-molecular weight compound, preferable examples thereof include chelating organic metal complexes, polynuclear or fused aromatic ring compounds, perylene compounds, coumarin compounds, styryl arylene compounds, silole compounds, oxazole compounds, oxathiazole compounds, oxadiazole compounds, and the like. If the light-emitting material is a polymer, examples thereof include poly-para-phenylene compounds, poly-para-phenylene vinylene compounds, polythiophene compounds, polyacetylene compounds, polyfluorene compounds and the like. Specifically preferable examples include, but are not limited to, the following exemplary compounds (VII-1) to (VII-17).

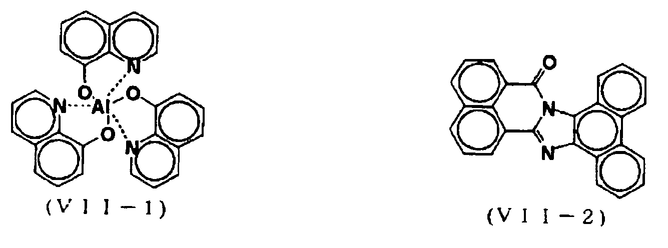

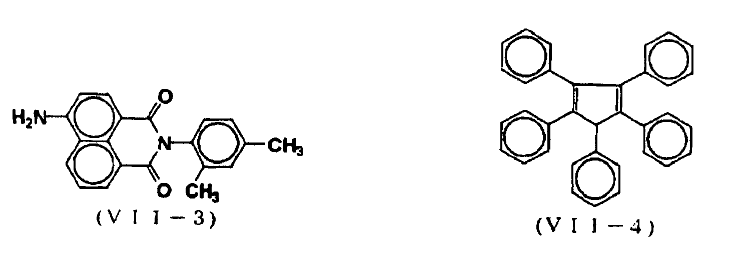

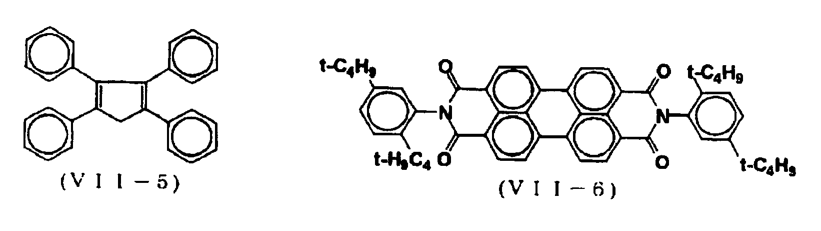

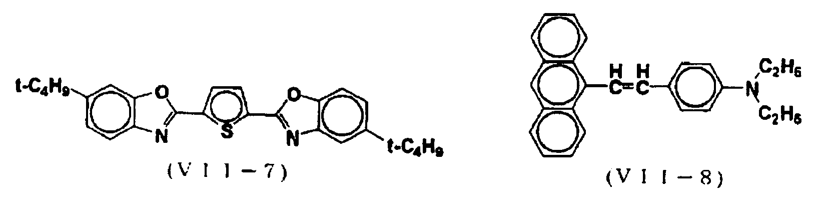

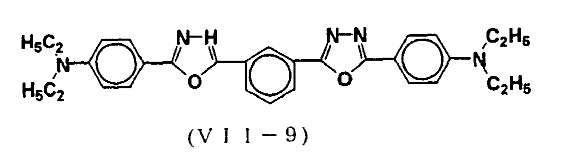

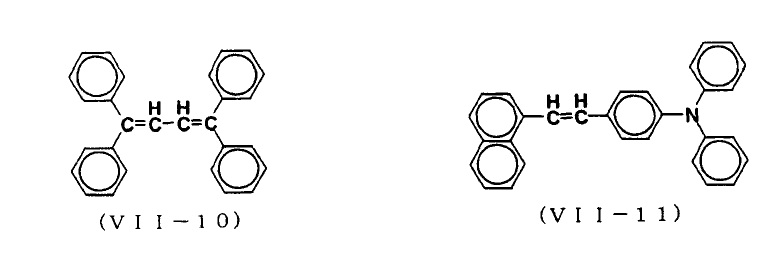

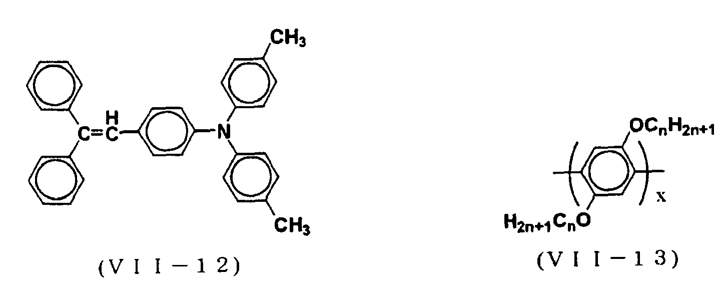

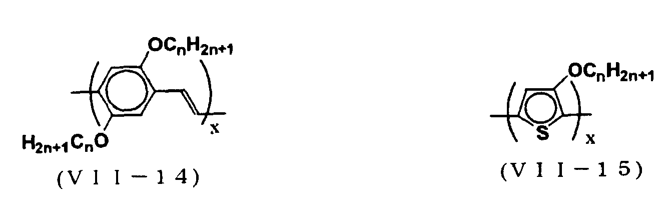

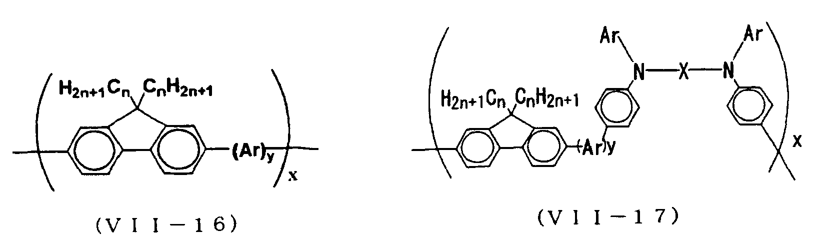

In the exemplary compounds (VII-1) to (VII-17), each of Ar and X is a monovalent or divalent group having a structure similar to Ar and X shown in Formulae (II-1) and (II-2); each of n and x is an integer of 1 or more; and y is 0 or 1.

A dye compound different from the light-emitting material may be doped as a guest material into the light-emitting material, for improvement in durability or luminous efficiency of the organic electroluminescent device 10. Doping is performed by vapor co-deposition when the light-emitting layer is formed by vacuum deposition, while by mixing to a solution or dispersion when the light-emitting layer is formed by coating/drying of the solution or dispersion. The degree of the dye compound doping in the light-emitting layer is approximately 0.001 to approximately 40 wt%, preferably approximately 0.01 to approximately 10 wt%.

Examples of the dye compound used in doping include an organic compound having good compatibility with the light-emitting material and giving no prevention to form a favorable thin-film light-emitting layer, and favorable examples thereof include DCM compounds, quinacridone compounds, rubrene compounds, porphyrin compounds and the like. Specifically favorable examples thereof include, but are not limited to, the following compounds (VIII-1) to (VIII-4).

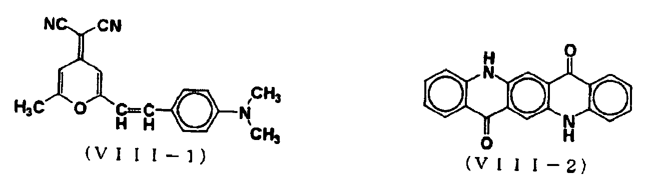

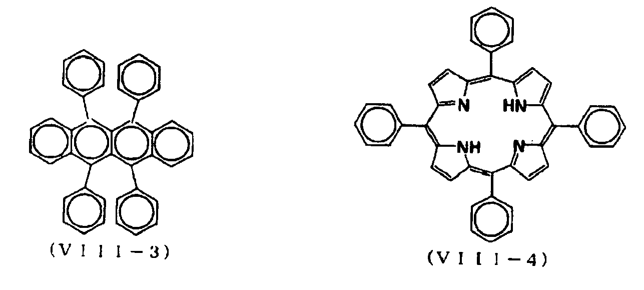

In the case where the organic electroluminescent device 10 has a configuration of the organic electroluminescent device shown in Figure 1, the light-emitting layer 5 has the charge-transporting polyether in addition to the light-emitting material. In the case where the organic electroluminescent device has a configuration of the organic electroluminescent device shown in Figure 2 or 3, the light-emitting layer 5 may be formed only with the light-emitting material, or alternatively, the light-emitting layer 5 may have the charge-transporting polyether in addition to the light-emitting material. In addition to the charge-transporting polyether, the light-emitting layer 5 may further have a charge-transporting material which is different from the charge-transporting polyether.
In the case where the light-emitting layer 5 has the charge-transporting polyether or the charge-transporting material other than the charge-transporting polyether, the charge-transporting polyether may be added to and dispersed in the light-emitting material in an amount in the range of about 1 to about 50 wt%, or alternatively, a charge-transporting material other than the charge-transporting polyether may be added to and dispersed in the light-emitting polymer in an amount in the range of about 1 to about 50 wt% before preparation of the light-emitting layer, in view of improving electrical properties and light-emitting characteristics.

In the case where the organic electroluminescent device 10 has a configuration of the organic electroluminescent device shown in Figure 4, the light-emitting layer 7 having a carrier-transporting property is an organic compound layer which has the charge-transporting polyether and a light-emitting material (such as a material having any one of the light-emitting compounds (VII-1) to (VII-17)) in an amount of 50 wt% or less relative to the total amount of the layer and is dispersed in the charge-transporting polyether and is imparted with a function (hole- or electron-transporting property) in accordance with purposes. In such a case, a charge-transporting material other than the charge-transporting polyether may be dispersed in an amount of 10 to 50 wt% relative to the total amount of the layer for control of the balance of hole and electron injected.

Preferable examples of the charge-transporting material for adjustment of electron transfer efficiency of the carrier-transporting light-emitting layer 7 include an oxadiazole compound, a nitro-substituted fluorenone compound, a diphenoquinone compound, a thiopyranedioxide compound, a fluorenylidenemethane compound and the like. More preferable examples thereof include the exemplary compounds (V-1) to (V-3). The charge-transporting material for use is preferably an organic compound having no strong electronic interaction with the charge-transporting polyether, and preferable examples thereof include the following compound (19).

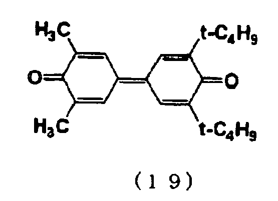

Similarly for adjustment of hole mobility of the carrier-transporting light-emitting layer 7, the hole-transporting material is preferably a tetraphenylenediamine compound, a triphenylamine compound, a carbazole compound, a stilbene compound, an aryl hydrazone compound, a porphyrin compound, or the like, and specifically favorable examples thereof include the exemplary compounds (VI-1) to (VI-7). Among these, tetraphenylenediamine compounds are preferable, because they are more compatible with the charge-transporting polyether.

In the case where the organic electroluminescent device 10 has a configuration of the organic electroluminescent device shown in Figure 1, 2, 3 or 4, a metal element allowing vacuum deposition and having a small work function permitting electron injection is used for the rear-face electrode 8, and particularly favorable examples thereof include magnesium, aluminum, silver, indium, the alloys thereof, metal halogen compounds such as lithium fluoride or lithium oxide, metal oxides, and alkali metals such as lithium, calcium, barium, or cesium.

A protective layer may be provided additionally on the rear-face electrode 8 for prevention of degradation of the device by water or oxygen. Specific examples of a material for the protective layer include metals such as In, Sn, Pb, Au, Cu, Ag, and A1; metal oxides such as MgO, SiO₂, or TiO₂; and resins such as polyethylene resin, polyurea resin, or polyimide resin. Vacuum deposition, sputtering, plasma polymerization, CVD, or coating may be used in forming the protective layer.

Preparation of Organic electroluminescent device
The organic electroluminescent device 10 shown in any one of Figures 1 to 4 can be prepared in the following manner: First, a buffer layer 3 is formed on a transparent electrode 2 previously formed on a transparent insulator substrate 1. The buffer layer 3 is formed to be a thin layer by applying the above-described components on the transparent electrode 2 by a vacuum evaporation method, a sputtering method, a CVD method or the like.

Then, a hole-transporting layer 4, a light-emitting layer 5, an electron-transporting layer 6, and/or a light-emitting layer 7 having a carrier-transporting property are formed on the buffer layer 3 according to the layer structure of each organic electroluminescent device 10. As described above, the hole-transporting layer 4, the light-emitting layer 5, the electron-transporting layer 6 and the light-emitting layer 7 having a carrier-transporting property can be formed by vacuum deposition of the material for each layer. Alternatively, the layer is formed for example by spin coating or dip coating, by using a coating solution obtained by dissolving materials for each layer in organic solvent.

When a polymer is used as the charge-transporting material or the light-emitting material, each layer is preferably formed by a casting method of using a coating solution, while the each layer may be formed by an inkjet method.

The film thickness of the formed buffer layer to be formed is preferably in the range of from equal to or approximately 1 nm to equal to or approximately 100 nm, particularly in the range of from equal to or approximately 10 nm to equal to or approximately 15 nm. The thickness of the carrier-transporting light-emitting layer 7 is preferably in the range of from equal to or approximately 30 nm to equal to or approximately 200 nm. Each material (the charge-transporting polyether, light-emitting material, etc.) may be present in the state of molecular dispersion or particular dispersion. In the case where a film-forming method using a coating solution is utilized, it is necessary to use a solvent which is capable of dissolving respective materials to obtain a coating solution in the molecular dispersion state, and the dispersion solvent should be properly selected considering the dispersibility and solubility of respective materials in order to obtain a coating solution in the state having particulates being dispersed. Various means such as ball mill, sand mill, paint shaker, attriter, homogenizer, and ultrasonicator are usable in preparing particular dispersion.

Finally, a rear-face electrode 8 is formed on the light-emitting layer 5, the electron-transporting layer 6 or the light-emitting layer 7 having a charge-transporting property by vacuum deposition or the like to give an organic electroluminescent device 10 shown in any one of Figure 1 to 4.

Display device
The display device of the exemplary embodiment has the organic electroluminescent device of the exemplary embodiment and a driving means for driving the organic electroluminescent device.
By having the configuration in which he organic electroluminescent device of the exemplary embodiment, the display device of the exemplary embodiment makes upsizing and producing of the display device easier while achieving high brightness, excellent stability and durability.

Examples of the display device include those, as specifically shown in Figures 1 to 4, having, as the driving means, a voltage-applying device 9 which is connected to the pair of the transparent electrode 2 and the rear-face electrode 8 of the organic electroluminescent device 10 and applies a DC voltage between the pair of electrodes.
Examples of the method for driving the organic electroluminescent device 10 by using the voltage-applying device 9 include a method including applying, between the pair of electrodes, a DC voltage of about 4 to about 20 V at a current density of about 1 to about 200 mA/cm² so that the organic electroluminescent device 10 emits light.

While a minimum unit (one pixel unit) of each of the exemplary embodiments has been referred for explaining the organic electroluminescent device of the present invention, the organic electroluminescent device is off course applicable to any display devices having plural pixel units (organic electroluminescent devices) arranged in a matrix form. The electrode pairs may be formed in a matrix form.

Any conventionally known technology, such as a simple matrix driving method of using multiple line electrodes and row electrodes and driving the row electrodes collectively according to the image information for each line electrode while the line electrodes, or active matrix driving method of using pixel electrodes allocated to respective pixels are scanned, may be used as the method of driving the display device.

### EXAMPLES

Hereinafter, the present invention will be described specifically with reference to Examples. However, the invention is not restricted by these Examples.

Synthesis of charge transporting polyether
Synthesis examples of the charge transporting polyethers are shown in the followings. In the synthesis examples, toluene is used as a solvent, and DCC (dichlorohexyl carbodiimide) is used as a conjugating agent. The amount of the DCC is 1/2 equivalent per equivalent of the charge transporting monomer.

Synthesis example 1
2.1 g of the compound (IX-1) is placed in a 50-ml three-necked, pear-shaped flask, and allowed to react under heating for 8 hours. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.5 g of charge transporting polyether (X-1). The molecular weight distribution is measured by GPC (gel permeation chromatography), and is found to have a molecular weight of 5.82 × 10⁵ (polystyrene standard), wherein Mw/Mn is 1.43.

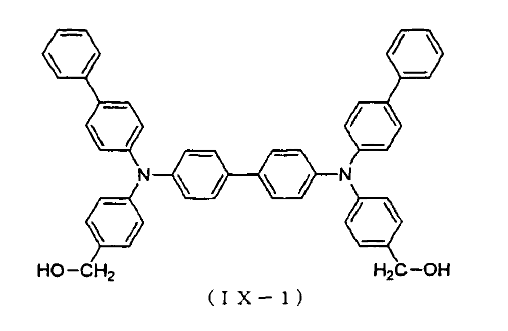

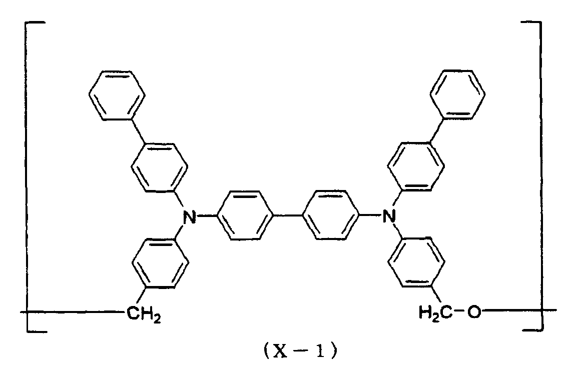

Synthesis example 2
2.5 g of the compound (IX-2) is placed in a 50-ml three-necked, pear-shaped flask, and allowed to react under heating for 8 hours. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.3 g of charge transporting polyether (X-2). The molecular weight distribution is measured by GPC (gel permeation chromatography), and is found to have a molecular weight of 9.52 × 10⁴ (polystyrene standard), wherein Mw/Mn is 1.38.

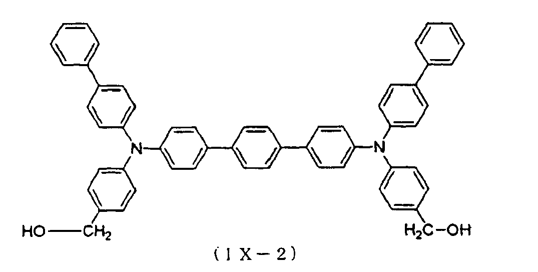

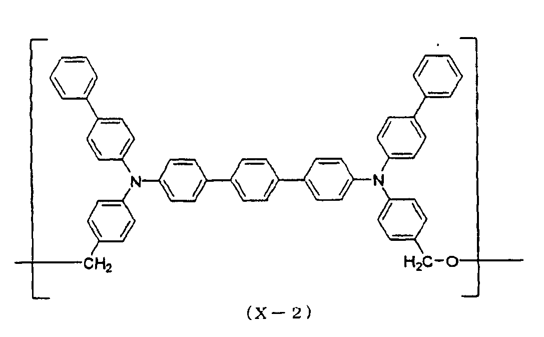

Synthesis example 3
4.7 g of the compound (IX-3) is placed in a 50-ml three-necked, pear-shaped flask, and allowed to react under heating for 8 hours. Thereafter, the flask is cooled to room temperature, and the reactant is dissolved in 50 ml of monochlorobenzene under heating.
Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 3.2 g of charge transporting polyether (X-3). The molecular weight distribution is measured by GPC (gel permeation chromatography), and is found to have a molecular weight of 9.66 × 10⁵ (polystyrene standard), wherein Mw/Mn is 1.25.

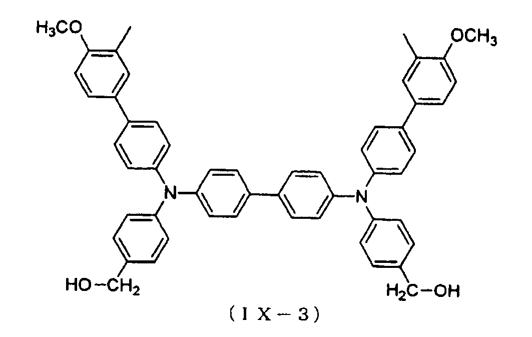

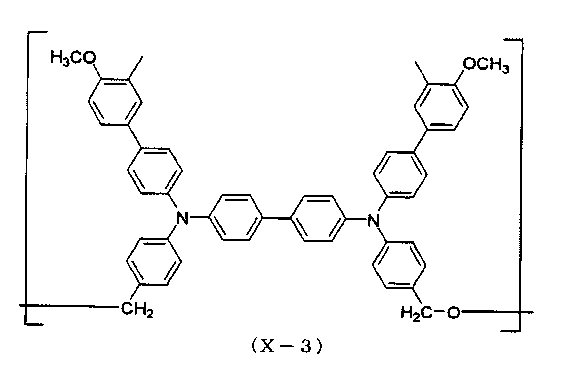

Synthesis example 4
3.2 g of the compound (IX-4) is placed in a 50-ml three-necked, pear-shaped flask, and allowed to react under heating for 8 hours. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.1 g of charge transporting polyether (X-4). The molecular weight distribution is measured by GPC (gel permeation chromatography), and is found to have a molecular weight of 8.39 × 10⁴ (polystyrene standard), wherein Mw/Mn is 1.45.

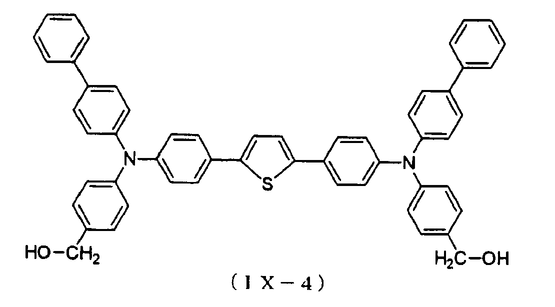

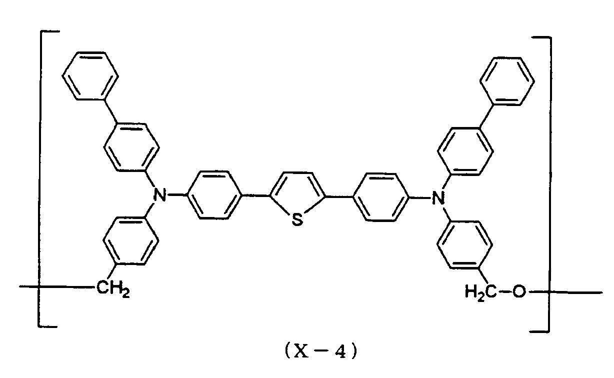

Preparation of Organic electroluminescent device
Then, an organic electroluminescent device is prepared in the following manner by using the charge-transporting polyether prepared as described above.

Example 1
A 2mm wide strip-shaped glass substrate is etched to form an ITO electrode. The ITO electrode is washed and dried. Subsequently, molybdenum trioxide (MoO₃) is applied onto the ITO electrode as a buffer layer material by vacuum deposition to form a buffer layer having a thickness of 10 nm.

Subsequently, 0.5 parts by weight a charge transporting polyether [exemplary compound (X-1)] as a charge transporting material and 0.5 parts by weight of the following exemplary compound (XI, polyfluorene compound, Mw ≈ 1× 10⁵) as a light-emitting polymer are mixed so as to prepare a 10% by weight chlorobenzene solution of the mixture. The resultant is filtered through a 0.1-µm polytetrafluoroethylene (PTFE) filter. The thus obtained solution is applied onto the buffer layer by spin coating to form a light-emitting layer having a thickness of 80 nm and a charge transporting property.

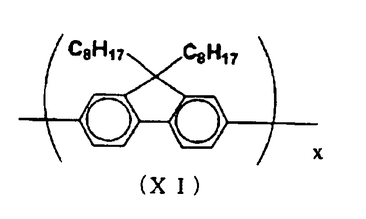

Finally, a Mg-Ag alloy is deposited thereon by vapor co-deposition, forming a rear-face electrode of 2 mm in width and 150 nm in thickness that crosses the ITO electrode. The effective area of the formed organic electroluminescent device is 0.04 cm².

Example 2
A 2mm wide strip-shaped glass substrate is etched to form an ITO electrode. The ITO electrode is washed and dried. Subsequently, molybdenum trioxide (MoO₃) is applied onto the ITO electrode as a buffer layer material by vacuum deposition to form a buffer layer having a thickness of 10 nm.

Subsequently, a 5% by weight chlorobenzene solution of a charge transporting polyether [exemplary compound (X-2)] as an electron hole transporting material is prepared, filtered through a 0.1-µm polytetrafluoroethylene (PTFE) filter, and then applied onto the buffer layer by spin coating thereby forming an hole transporting layer having a thickness of 30 nm.

After thoroughly drying the layer, sublimation purified Alq₃ (exemplary compound VII-1) as a luminescent material is placed in a tungsten boat, and evaporated by vacuum deposition to form a light-emitting layer having a thickness of 50 nm on the hole transporting layer. At this time, the degree of vacuum is 133.3 × 10⁻³Pa (1 × 10⁻⁵ Torr), and the boat temperature is 300°C.

Finally, a Mg-Ag alloy is deposited thereon by vapor co-deposition, forming a rear-face electrode of 2 mm in width and 150 nm in thickness that crosses the ITO electrode. The effective area of the formed organic electroluminescent device is 0.04 cm².

Example 3
A 2mm wide strip-shaped glass substrate is etched to form an ITO electrode. The ITO electrode is washed and dried. Subsequently, molybdenum trioxide (MoO₃) is applied onto the ITO electrode as a buffer layer material by vacuum deposition to form a buffer layer having a thickness of 10 nm.

Subsequently, a 5% by weight chlorobenzene solution of a charge transporting polyether [exemplary compound (X-3)] as an electron hole transporting material is prepared, filtered through a 0.1-µm polytetrafluoroethylene (PTFE) filter, and then applied onto the buffer layer by spin coating thereby forming an hole transporting layer having a thickness of 30 nm.

After thoroughly drying the layer, sublimation purified Alq₃ (exemplary compound VII-1) as a luminescent material is placed in a tungsten boat, and evaporated by vacuum deposition to form a light-emitting layer having a thickness of 50 nm on the hole transporting layer. At this time, the degree of vacuum is 133.3 × 10⁻³Pa (1 × 10⁻⁵ Torr), and the boat temperature is 300°C.

Finally, a Mg-Ag alloy is deposited thereon by vapor co-deposition, forming a rear-face electrode of 2 mm in width and 150 nm in thickness that crosses the ITO electrode. The effective area of the formed organic electroluminescent device is 0.04 cm².

Example 4
A 2mm wide strip-shaped glass substrate is etched to form an ITO electrode. The ITO electrode is washed and dried. Subsequently, molybdenum trioxide (MoO₃) is applied onto the ITO electrode as a buffer layer material by vacuum deposition to form a buffer layer having a thickness of 10 nm.

Subsequently, 0.5 parts by weight a charge transporting polyether [exemplary compound (X-4)] as a charge transporting material and 0.1 parts by weight of the following exemplary compound (XII, PPV (poly(phenylene vinylene)) compound, Mw ≈ 1 × 10⁵) as a light-emitting polymer are mixed so as to prepare a 10% by weight chlorobenzene solution of the mixture. The resultant is filtered through a 0.1-µm polytetrafluoroethylene (PTFE) filter. The thus obtained solution is applied onto the buffer layer by spin coating to form a light-emitting layer having a thickness of 80 nm and a charge transporting property.

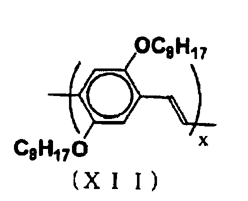

Finally, a Mg-Ag alloy is deposited thereon by vapor co-deposition, forming a rear-face electrode of 2 mm in width and 150 nm in thickness that crosses the ITO electrode. The effective area of the formed organic electroluminescent device is 0.04 cm².

Example 5
An organic electroluminescent device is prepared in a similar manner to Example 1, except that vanadium troxide (VO₃) is used as the material for forming the buffer layer.

Example 6
An organic electroluminescent device is prepared in a similar manner to Example 2, except that vanadium troxide (VO₃) is used as the material for forming the buffer layer.

Example 7
An organic electroluminescent device is prepared in a similar manner to Example 3, except that vanadium troxide (VO₃) is used as the material for forming the buffer layer.

Example 8
An organic electroluminescent device is prepared in a similar manner to Example 4, except that vanadium troxide (VO₃) is used as the material for forming the buffer layer.

Comparative Example 1
An organic electroluminescent device is prepared in a similar manner to Example 1, except that a light-emitting layer is formed directly on the ITO electrode-sided surface of an ITO electrode-carrying glass plate without forming the buffer layer.

Comparative Example 2
An organic electroluminescent device is prepared in a similar manner to Example 2, except that a light-emitting layer is formed directly on the ITO electrode-sided surface of an ITO electrode-carrying glass plate without forming the buffer layer.

Comparative Example 3
An organic electroluminescent device is prepared in a similar manner to Example 3, except that a light-emitting layer is formed directly on the ITO electrode-sided surface of an ITO electrode-carrying glass plate without forming the buffer layer.

Comparative Example 4
An organic electroluminescent device is prepared in a similar manner to Example 4, except that a light-emitting layer is formed directly on the ITO electrode-sided surface of an ITO electrode-carrying glass plate without forming the buffer layer.

Comparative Example 5
An organic electroluminescent device is prepared in a similar manner to Example 3, except that a charge-transporting polymer having a vinyl skeleton [compound (XIII), Mw: 5.46×10⁴ (polystyrene standard)] is used as a hole-transporting material in place of the charge-transporting polyether.

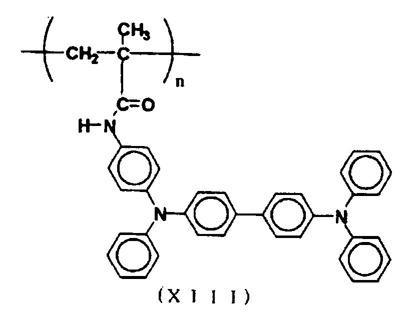

Comparative Example 6
An organic electroluminescent device is prepared in a similar manner to Example 3, except that a charge-transporting polymer having a polycarbonate skeleton [compound (XIV), Mw: 7.83×10⁴ (polystyrene standard)] is used as a hole-transporting material in place of the charge-transporting polyether.

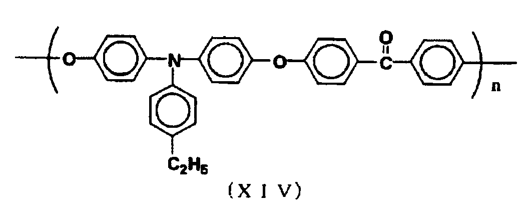

Comparative Example 7
An organic electroluminescent device is prepared in a similar manner to Example 4, except that a charge-transporting polymer having a vinyl skeleton [compound (XIII), Mw: 5.46×10⁴ (polystyrene standard)] is used as a hole-transporting material in place of the charge-transporting polyether.

Comparative Example 8
An organic electroluminescent device is prepared in a similar manner to Example 4, except that a charge-transporting polymer having a polycarbonate skeleton [compound (XIV), Mw: 7.83 × 10⁴ (polystyrene standard)] is used as a hole-transporting material in place of the charge-transporting polyether.

Evaluation
The start-up voltage (driving voltage), the maximum brightness, and the drive current density at the maximum brightness when DC voltage is applied between the ITO electrode (plus), and the Mg-Ag rear-face electrode (minus) of each of the organic electroluminescent devices thus prepared under vacuum (133.3×10⁻³ Pa (10⁻⁵ Torr)) for light emission are evaluated. The results are summarized in Table 1.
Separately, the emission lifetime (device lifetime) of each organic electroluminescent device is determined under dry nitrogen. The emission lifetime is determined at a current giving an initial brightness of 50cd/m², and the device lifetime (hour) is the period until the brightness decreases to half of the initial value under constant-current drive. The device lifetime then is also shown in Table 1.

**Table 1**

| | Start-up voltage (V) | Maximum brightness (cd/m²) | Drive current density (mA/cm²) | Device lifetime (hour) |
|---|---|---|---|---|
| Example 1 | 2.8 | 1120 | 6.8 | 80 |
| Example 2 | 2.2 | 1300 | 7.2 | 110 |
| Example 3 | 2.6 | 980 | 7.0 | 90 |
| Example 4 | 2.4 | 1050 | 6.6 | 60 |
| Example 5 | 3.0 | 1020 | 7.0 | 70 |
| Example 6 | 2.4 | 1250 | 7.4 | 90 |
| Example 7 | 2.8 | 880 | 7.6 | 80 |
| Example 8 | 2.6 | 940 | 7.2 | 70 |
| Comparative example 1 | 4.5 | 680 | 5.8 | 40 |
| Comparative example 2 | 3.4 | 800 | 5.0 | 40 |
| Comparative example 3 | 3.6 | 440 | 4.8 | 30 |
| Comparative example 4 | 4.0 | 400 | 6.0 | 30 |
| Comparative example 5 | 3.6 | 1080 | 7.0 | 50 |
| Comparative example 6 | 2.8 | 1150 | 6.8 | 60 |
| Comparative example 7 | 3.1 | 840 | 6.4 | 60 |
| Comparative example 8 | 3.0 | 940 | 6.2 | 40 |

As is clearly understood from Table 1, the organic electroluminescent devices shown in Examples 1 to 8 provide improved in charge-injecting efficiency and charge balance, as well as are superior stability, higher brightness and longer lifetime than the organic electroluminescent devices of Comparative examples 1 to 8.

## Claims

1. An organic electroluminescent device (10) comprising an anode and a cathode forming a pair of electrodes (2,8), at least one electrode (2) being transparent or translucent, and a buffer layer (3) and an organic compound layer being disposed between the anode and the cathode, **characterised in that**
the organic compound layer (4) comprises one or more layers including at least a light-emitting layer (5);
at least one of the layers of the organic compound layer comprises at least one charge-transporting polyether represented by Formula (I);
at least one of the layers comprises the charge-transporting polyether being provided in contact with the buffer layer; and
the buffer layer is provided in contact with the anode and comprises at least one charge injection material selected from the group consisting of an inorganic oxide, an inorganic nitride, and an inorganic oxynitride: Formula (I) **R**-**O**-[**A**-**O**]**ₚ**-**R**
in Formula (I), A represents at least one structure represented by Formula (II-1) or
(II-2); R represents a hydrogen atom, an alkyl group, a substituted or unsubstituted aryl group,
a substituted or unsubstituted aralkyl group, an acyl group, or a group represented by -CONH-R' (in which R' represents a hydrogen atom, an alkyl group, a substituted or unsubstituted aryl group, or a substituted or unsubstituted aralkyl group); and p is an integer of 5 to 5,000, 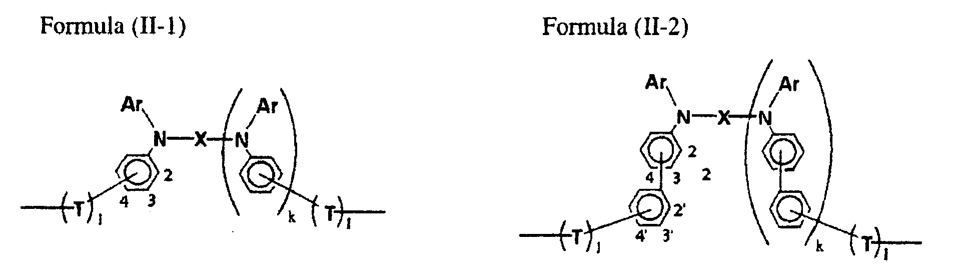 in Formulae (II-1) and (II-2), Ar represents a substituted or unsubstituted monovalent aromatic group; X represents a substituted or unsubstituted divalent aromatic group; k and I each is 0 or 1; and T represents a divalent straight-chain hydrocarbon having 1 to 6 carbon atoms or a branched hydrocarbon having 2 to 10 carbon atoms.

2. The organic electroluminescent device of claim 1, wherein the buffer layer comprises at least one of molybdenum oxide and vanadium oxide.

3. The organic electroluminescent device of claim 1, wherein Ar in Formulae (II-1) and (II-2) represents a monovalent aromatic group selected from the group consisting of a substituted or unsubstituted benzene group, a substituted or unsubstituted monovalent biphenyl group, a substituted or unsubstituted monovalent naphthalene group, and a substituted or unsubstituted monovalent fluorene group.

4. The organic electroluminescent device of claim 1, wherein T in Formulae (II-1) and (II-2) represents -CH₂-, -(CH₂)₂-, -(CH₂)₃-, or -(CH₂)₄-.

5. The organic electroluminescent device of claim 1, wherein the thickness of the buffer layer is in the range of about 1 nm to about 15 nm.

6. The organic electroluminescent device of claim 1, wherein the organic compound layer comprises the light-emitting layer and an electron-transporting layer, at least the light-emitting layer comprises at least one charge-transporting polyether represented by Formula (I), and the buffer layer is disposed between the anode and the light-emitting layer.

7. The organic electroluminescent device of claim 6, wherein the light-emitting layer further comprises a charge-transporting material other than the charge-transporting polyether.

8. The organic electroluminescent device of claim 1, wherein the organic compound layer comprises a hole-transporting layer, the light-emitting layer, and an electron-transporting layer, at least the hole-transporting layer comprises at least one charge-transporting polyether represented by Formula (I), and the buffer layer is disposed between the anode and the hole-transporting layer.

9. The organic electroluminescent device of claim 8, wherein the light-emitting layer further comprises a charge-transporting material other than the charge-transporting polyether.

10. The organic electroluminescent device of claim 1, wherein the organic compound layer comprises a hole-transporting layer and the light-emitting layer, at least the hole-transporting layer comprises at least one charge-transporting polyether represented by Formula (I), and the buffer layer is disposed between the anode and the hole-transporting layer.

11. The organic electroluminescent device of claim 10, wherein the light-emitting layer further comprises a charge-transporting material other than the charge-transporting polyether.

12. The organic electroluminescent device of claim 1, wherein the organic compound layer consists of the light-emitting layer, the light-emitting layer has a charge-transporting property, the light-emitting layer comprises at least one charge-transporting polyether represented by Formula (I), and the buffer layer is disposed between the anode and the light-emitting layer.

13. The organic electroluminescent device of claim 12, wherein the light-emitting layer further comprises a charge-transporting material other than the charge-transporting polyether.

14. A display device comprising:
a substrate;
a plurality of organic electroluminescent devices disposed on the substrate and arranged in a matrix form; and
a driving unit that drives the organic electroluminescent devices,
each of the organic electroluminescent devices being the organic electroluminescent device of any one of claims 1 to 13.

## Patentansprüche

1. Organische Elektrolumineszenzvorrichtung (10) aufweisend eine Anode und eine Kathode, die ein Elektrodenpaar (2, 8) bilden, wobei mindestens eine Elektrode (2) transparent oder transluzent ist, und eine Pufferschicht (3) und eine organische Verbindungsschicht, die sich zwischen der Anode und der Kathode befinden, **dadurch gekennzeichnet, dass**
die organische Verbindungsschicht (4) eine oder mehrere Schichten aufweist, die mindestens eine lichtemittierende Schicht (5) enthalten;
mindestens eine der Schichten der organischen Verbindungsschicht mindestens einen ladungstransportierenden Polyether aufweist, der repräsentiert wird durch Formel (I);
mindestens eine der Schichten, die den ladungstransportierenden Polyether aufweisen, in Kontakt mit der Pufferschicht vorgesehen ist; und
die Pufferschicht in Kontakt mit der Anode vorgesehen ist und mindestens ein Ladungsinjektionsmaterial aufweist, das ausgewählt ist aus der Gruppe, die aus einem anorganischen Oxid, einem anorganischen Nitrid und einem anorganischen Oxynitrid besteht: 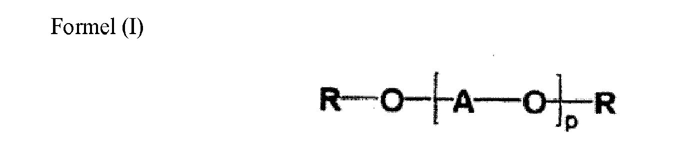 In Formel (I) repräsentiert A mindestens eine Struktur, die repräsentiert wird durch Formel (II-1) oder (II-2); R repräsentiert ein Wasserstoffatom, eine Alkylgruppe, eine substituierte oder unsubstituierte Arylgruppe, eine substituierte oder unsubstituierte Aralkylgruppe, eine Acylgruppe oder eine Gruppe, die repräsentiert wird durch -CONH-R' (in der R' ein Wasserstoffatom, eine Alkylgruppe, eine substituierte oder unsubstituierte Arylgruppe oder eine substituierte oder unsubstituierte Aralkylgruppe repräsentiert); und p ist eine ganze Zahl von 5 bis 5000, 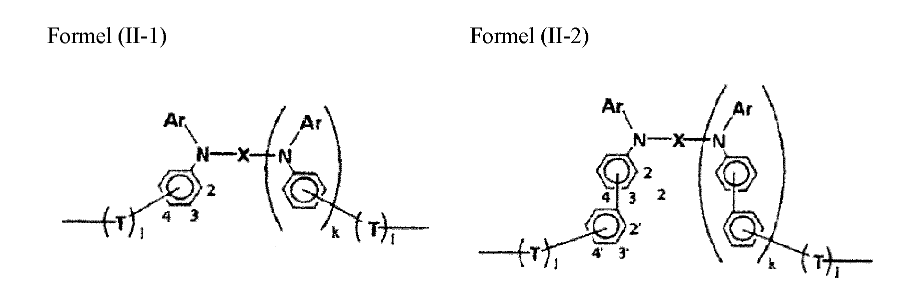 in den Formeln (II-1) und (II-2) repräsentiert Ar eine substituierte oder unsubstituierte, monovalente, aromatische Gruppe; X repräsentiert eine substituierte oder unsubstituierte, divalente, aromatische Gruppe; k und 1 sind jeweils 0 oder 1; und T repräsentiert einen divalenten geradkettigen Kohlenwasserstoff mit 1 bis 6 Kohlenstoffatomen oder einen verzweigten Kohlenwasserstoff mit 2 bis 10 Kohlenstoffatomen.

2. Organische Elektrolumineszenzvorrichtung nach Anspruch 1, bei der die Pufferschicht Molybdänoxid und/oder Vanadiumoxid aufweist.

3. Organische Elektrolumineszenzvorrichtung nach Anspruch 1, bei der Ar in den Formeln (II-1) und (II-2) eine monovalente, aromatische Gruppe repräsentiert, die ausgewählt ist aus der Gruppe, die aus einer substituierten oder unsubstituierten Benzolgruppe, einer substituierten oder unsubstituierten, monovalenten Biphenylgruppe, einer substituierten oder unsubstituierten, monovalenten Naphthalingruppe, und einer substituierten oder unsubstituierten, monovalenten Fluorengruppe besteht.

4. Organische Elektrolumineszenzvorrichtung nach Anspruch 1, bei der T in den Formeln (II-1) und (II-2) -CH₂-, -(CH₂)₂-, -(CH₂)₃- oder -(CH₂)₄- repräsentiert.

5. Organische Elektrolumineszenzvorrichtung nach Anspruch 1, bei der die Dicke der Pufferschicht in dem Bereich von etwa 1 nm bis etwa 15 nm liegt.

6. Organische Elektrolumineszenzvorrichtung nach Anspruch 1, bei der die organische Verbindungsschicht die lichtemittierende Schicht und eine Elektronentransportschicht aufweist, wobei mindestens die lichtemittierende Schicht mindestens einen ladungstransportierenden Polyether aufweist, der repräsentiert wird durch Formel (I), und wobei sich die Pufferschicht zwischen der Anode und der lichtemittierenden Schicht befindet.

7. Organische Elektrolumineszenzvorrichtung nach Anspruch 6, bei der die lichtemittierende Schicht außerdem ein anderes Ladungstransportmaterial als den ladungstransportierenden Polyether aufweist.

8. Organische Elektrolumineszenzvorrichtung nach Anspruch 1, bei der die organische Verbindungsschicht eine Lochtransportschicht, die lichtemittierende Schicht und eine Elektronentransportschicht aufweist, wobei mindestens die Lochtransportschicht mindestens einen ladungstransportierenden Polyether aufweist, der repräsentiert wird durch Formel (I), und sich die Pufferschicht zwischen der Anode und der Lochtransportschicht befindet.

9. Organische Elektrolumineszenzvorrichtung nach Anspruch 8, bei der die lichtemittierende Schicht außerdem ein anderes Ladungstransportmaterial als den ladungstransportierenden Polyether aufweist.

10. Organische Elektrolumineszenzvorrichtung nach Anspruch 1, bei der die organische Verbindungsschicht eine Lochtransportschicht und die lichtemittierende Schicht aufweist, wobei mindestens die Lochtransportschicht mindestens einen ladungstransportierenden Polyether aufweist, der repräsentiert wird durch Formel (I), und sich die Pufferschicht zwischen der Anode und der Lochtransportschicht befindet.

11. Organische Elektrolumineszenzvorrichtung nach Anspruch 10, bei der die lichtemittierende Schicht außerdem ein anderes Ladungstransportmaterial als den ladungstransportierenden Polyether aufweist.

12. Organische Elektrolumineszenzvorrichtung nach Anspruch 1, bei der die organische Verbindungsschicht aus der lichtemittierenden Schicht besteht, die lichtemittierende Schicht eine Ladungstransporteigenschaft hat, die lichtemittierende Schicht mindestens einen ladungstransportierenden Polyether aufweist, der repräsentiert wird durch Formel (I), und sich die Pufferschicht zwischen der Anode und der lichtemittierenden Schicht befindet.

13. Organische Elektrolumineszenzvorrichtung nach Anspruch 12, bei der die lichtemittierende Schicht außerdem ein anderes Ladungstransportmaterial als den ladungstransportierenden Polyether aufweist.

14. Anzeigevorrichtung aufweisend.
ein Substrat;
eine Mehrzahl von organischen Elektrolumineszenzvorrichtungen, die sich auf dem Substrat befinden und in einer Matrixform angeordnet sind; und
eine Treibeinheit, die die organischen Elektrolumineszenzvorrichtungen antreibt, wobei jede der organischen Elektrolumineszenzvorrichtungen die organische Elektrolumineszenzvorrichtung nach einem der Ansprüche 1 bis 13 ist.

## Revendications

1. Dispositif électroluminescent organique (10) comprenant une anode et une cathode formant une paire d'électrodes (2, 8), au moins une électrode (2) étant transparente ou translucide, et une couche tampon (3) et une couche de composé organique disposée entre l'anode et la cathode, **caractérisé en ce que**
la couche de composant organique (4) comprend une couche ou davantage avec au moins une couche émettrice de lumière (5) ;
au moins l'une des couches de la couche de composant organique est pourvue d'au moins un polyéther de transport de charge représenté par la Formule (I) :
au moins l'une des couches est pourvue du polyéther de transport de charge situé en contact avec la couche tampon ; et
la couche tampon située en contact avec l'anode est pourvue d'au moins un matériau d'injection de charge sélectionné parmi le groupe constitué d'un oxyde inorganique, d'un nitrure inorganique et d'un oxynitrure inorganique : 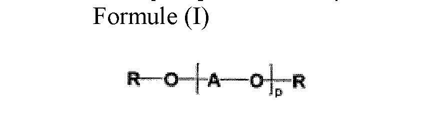
dans la Formule (I), A représente au moins une structure représentée par la Formule (II-1) ou par la Formule (II-2) ; R représente un atome d'hydrogène, un groupe alkyle, un groupe aryle substitué ou non substitué, un groupe aralkyle substitué ou non substitué, un groupe acyle ou un groupe représenté par -CONH-R' (dans lequel R' représente un atome d'hydrogène, un groupe alkyle, un groupe aryle substitué ou non substitué ou un groupe aralkyle substitué ou non substitué) ; et p est un nombre entier de 5 à 5000, 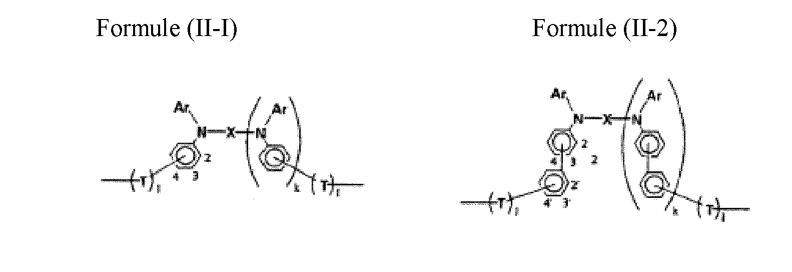 dans les Formules (II-1) et (11-2), Ar représente un groupe aromatique monovalent substitué ou non substitué ; X représente un groupe aromatique divalent substitué ou non substitué ; k et I représentent chacun 0 ou 1 ; et T représente un hydrocarbure divalent à chaîne droite ayant 1 à 6 atomes de carbone ou un hydrocarbure ramifié ayant 2 à 10 atomes de carbone.

2. Dispositif électroluminescent organique de la revendication 1, dans lequel la couche tampon est pourvue d'au moins l'un d'un oxyde de molybdène et d'un oxyde de vanadium.

3. Dispositif électroluminescent organique de la revendication 1, dans lequel Ar dans les formules (II-1) et (II-2) représente un groupe aromatique monovalent sélectionné parmi le groupe constitué d'un groupe benzène substitué ou non substitué, d'un groupe biphényle monovalent substitué ou non substitué, d'un groupe naphtalène monovalent substitué ou non substitué et d'un groupe fluorène monovalent substitué ou non substitué.

4. Dispositif électroluminescent organique de la revendication 1, dans lequel T dans les Formules (II-1) et (II-2) représente -CH₂-, -(CH₂)₂-, -(CH₂)₃, ou -(CH₂)₄-,

5. Dispositif électroluminescent organique de la revendication 1, dans lequel l'épaisseur de la couche tampon se situe dans la plage de 1nm à environ 15 nm.

6. Dispositif électroluminescent organique de la revendication 1, dans lequel la couche de composé organique est pourvue de la couche émettrice de lumière et d'une couche de transport d'électrons, au moins la couche émettrice de lumière est pourvue d'au moins un polyéther de transport de charge représenté par la Formule (I) et la couche tampon est disposée entre l'anode et la couche émettrice de lumière.

7. Dispositif électroluminescent de la revendication 6, dans lequel la couche émettrice de lumière contient en outre un matériau de transport de charge autre que le polyéther de transport de charge.

8. Dispositif électroluminescent organique de la revendication 1, dans lequel la couche de composé organique est pourvue d'une couche de transport de trous, de la couche émettrice de lumière et d'une couche de transport d'électrons, au moins la couche de transport d'électrons est pourvue d'au moins un polyéther de transport de charge représenté par la Formule (I) et la couche tampon est disposée entre l'anode et la couche de transport de trous.

9. Dispositif électroluminescent organique de la revendication 8, dans lequel la couche émettrice de lumière est pourvue d'un matériau de transport de charge autre que le polyéther de transport de charge.

10. Dispositif électroluminescent organique de la revendication 1, dans lequel la couche de composé organique est pourvue d'une couche de transport de trous et de la couche émettrice de lumière, au moins la couche de transport de trous est pourvue d'au moins un polyéther de transport de charge représenté par la Formule (I) et la couche tampon est disposée entre l'anode et la couche de transport de trous.

11. Dispositif électroluminescent organique de la revendication 10, dans lequel la couche émettrice de lumière est en outre pourvue d'un matériau de transport de charge autre que le polyéther de transport de charge.

12. Dispositif électroluminescent organique de la revendication 1, dans lequel la couche de composé organique consiste d'une couche émettrice de lumière, la couche émettrice de lumière ayant une propriété de transport de charge, la couche émettrice de lumière étant pourvue d'au moins un polyéther de transport de charge représenté par la Formule (I) et la couche tampon étant disposée entre l'anode et la couche émettrice de lumière.

13. Dispositif électroluminescent organique de la revendication 12, dans lequel la couche émettrice de lumière est pourvue d'un matériau de transport de charge autre que le polyéther de transport de charge.

14. Dispositif d'affichage comprenant :
un substrat ;
une pluralité de dispositifs électroluminescents organiques disposés sur le substrat et agencés sous forme de matrice ; et
une unité de commande qui commande les dispositifs électroluminescents organiques, chacun des dispositifs électroluminescents organiques étant le dispositif électroluminescent organique de l'une quelconque des revendications 1 à 13.
